(19) Europäisches Patentamt / European Patent Office / Office européen des brevets

(11) **EP 2 973 712 B1**

(12) **EUROPEAN PATENT SPECIFICATION**

(45) Date of publication and mention
of the grant of the patent:
**05.05.2021 Bulletin 2021/18**

(21) Application number: **14780028.8**

(22) Date of filing: **12.03.2014**

(51) Int Cl.:
*H01L 31/068* (2012.01)     *H01L 31/0352* (2006.01)
*B82Y 10/00* (2011.01)     *B82Y 40/00* (2011.01)

(86) International application number:
**PCT/US2014/024866**

(87) International publication number:
**WO 2014/165228 (09.10.2014 Gazette 2014/41)**

(54) **HIGHLY EFFICIENT OPTICAL TO ELECTRICAL CONVERSION DEVICE**

HOCHEFFIZIENTE VORRICHTUNG ZUR UMWANDLUNG VON OPTISCHER IN ELEKTRISCHE ENERGIE

DISPOSITIF DE CONVERSION OPTIQUE/ÉLECTRIQUE DE HAUTE EFFICACITÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.03.2013  US 201361777771 P**
          **22.10.2013  US 201361893894 P**

(43) Date of publication of application:
**20.01.2016  Bulletin 2016/03**

(73) Proprietor: **The Regents of the University of California**
**Oakland, CA 94607-5200 (US)**

(72) Inventors:
• **LO, Yu-Hwa**
  **San Diego, CA 92130 (US)**
• **ZHOU, Yuchun**
  **San Diego, CA 92122 (US)**

(74) Representative: **AWA Sweden AB**
**P.O. Box 11394**
**404 28 Göteborg (SE)**

(56) References cited:
**WO-A1-2008/140627      WO-A1-2009/071916
WO-A1-2012/057604      WO-A1-2012/057604
WO-A2-2013/003828      WO-A2-2013/003828
US-A1- 2010 288 344      US-A1- 2011 309 306
US-A1- 2012 196 401      US-A1- 2012 196 401
US-A1- 2012 322 164**

**Description**

TECHNICAL FIELD

This patent document relates to signal amplification techniques using nanoscale semiconductor materials.

BACKGROUND

Nanotechnology provides techniques or processes for fabricating structures, devices, and systems with features at a molecular or atomic scale, e.g., structures in a range of one to hundreds of nanometers in some applications. For example, nano-scale devices can be configured to sizes similar to some large molecules, e.g., biomolecules such as enzymes. Nano-sized materials used to create a nanostructure, nanodevice, or a nanosystem can exhibit various unique properties, e.g., including optical properties, that are not present in the same materials at larger dimensions and such unique properties can be exploited for a wide range of applications Document US 2012/196401 A1 discloses techniques for fabricating nanowire/ microwire-based solar cells having a cylindrical p-n junction configuration. The emitter layer is highly doped with either an n-type or a p-type dopant, e.g., at a concentration of from about $1 \times 10^{19}$ cm$^{-3}$ to about $1 \times 10^{21}$ cm$^{-3}$, so as to have a polarity opposite to that of the substrate and wires.

SUMMARY

Techniques, systems, and devices are described for highly-efficient optical to electrical energy conversion, e.g., which exceed the highest efficiencies achievable for single-junction Si according to Shockley-Queisser theory.
In one aspect according to the present invention, an optical-to-electrical energy conversion device is presented. The optical-to-electrical energy conversion device includes a substrate formed of a doped semiconductor material, in which the substrate includes a first region and a second region. The optical-to-electrical energy conversion device includes an array of multilayered nanostructures protruding from the first region of the substrate, in which the multilayered nanostructures are formed of a first co-doped semiconductor material covered by a layer of a second co-doped semiconductor material forming a core-shell structure, and in which the layer covers at least a portion of the doped semiconductor material of the substrate in the second region. The first and second co-doped semiconductor materials include electron acceptor dopants and electron donor dopants, in which the first co-doped semiconductor material includes a greater concentration of one type of the acceptor or donor dopants than the other type dopants, and the second co-doped semiconductor material includes a greater concentration of the other type dopants than the one type dopants. The first and the second co-doped semiconductor material include the acceptor and donor dopants at a concentration level of at least $1 \times 10^{18}$ cm$^{-3}$ to provide co-doped, heavily compensated junction structures. The optical-to-electrical energy conversion device includes an electrode formed on the layer-covered portion of the substrate in the second region. The multilayered nanostructures of the optical-to-electrical energy conversion device are structured to provide an optical active region capable of absorbing photons from light at one or more wavelengths to generate an electrical signal presented at the electrode.
In another aspect, devices and methods are described for optical to electrical signal conversion and signal amplification with high efficiency based on a cascaded exciton ionization (CEI) carrier multiplication mechanism. Exemplary CEI devices and methods can be implemented in a variety of applications including photovoltaics, communications, and imaging, among others. In some implementations, an exemplary CEI device includes a substrate formed of a doped silicon material, in which the substrate includes a first region and a second region. The exemplary CEI device includes an array of multilayered nanowire structures protruding from the first region of the substrate, in which the nanowire structures are formed of a first co-doped silicon material covered by a layer of a second co-doped silicon material forming a core-shell structure, and in which the layer covers at least a portion of the substrate in the second region. The first and second co-doped silicon materials include electron acceptor dopants and electron donor dopants, in which the first co-doped silicon material includes a greater concentration of one type of the acceptor or donor dopants than the other type dopants, and the second co-doped silicon material includes a greater concentration of the other type dopants than the one type dopants. The exemplary CEI device includes an electrode formed on the layer-covered potion of the substrate in the second region. The multilayered nanowire structures of the exemplary CEI device are structured to provide an optical active region capable of absorbing photons from light at one or more wavelengths to generate an electrical signal presented at the electrode via a cascaded exciton ionization (CEI) mechanism.
In another aspect according to the present invention, a method to convert optical energy to electrical energy is presented. The method comprises providing an optical-to-electrical energy conversion device according to the present invention, illuminating a surface of said optical-to-electrical energy conversion device, generating an electrical signal from the light obtained by said optical-to-energy conversion via a cascaded exciton ionization (CEI) mechanism at the array of multilayered nanostructures, wherein the electrical signal is presented at an electrode on the doped semiconductor substrate of the surface, and providing the generated electrical signal to an electrical circuit.

The subject matter described in this patent document can be implemented in specific ways that provide one or more of the following features. For example, the disclosed technology includes an engineered physical mechanism, cascaded exciton ionization (CEI), to amplify the photoresponse of core-shell semiconductor nanoscale structures (e.g., silicon nanowires) without the constraint of the MEG or avalanche mechanism. In some implementations, for example, the disclosed CEI process can be implemented using a nanoscale device having a heavily-doped, partially compensated p-n junction in which the p-region contains a substantial amount of donors and the n-region contains a substantial amount of acceptors. An exemplary salient feature of the disclosed CEI technology is that, unlike avalanche multiplication, the CEI process can take place at low or even zero bias. As a result, the CEI process can be used for detection of optical signals and energy conversion such as photovoltaics, or even optical cooling (e.g., to remove heat from the area under illumination).

BRIEF DESCRIPTION OF THE DRAWINGS

FIG. 1 shows a schematic of an exemplary optical-to-electrical energy conversion device including a co-doped, heavily compensated p/n junction structure.

FIGS. 2A-2C show exemplary optical and scanning electron micrographs of exemplary Si nanowire based optical-to-electrical energy conversion devices with the co-doped, heavily compensated p/n junction structure.

FIG. 2D shows a schematic of an exemplary co-doped p+/n+ junction structure of the disclosed optical-to-electrical energy conversion devices.

FIG. 3 shows exemplary diagrams showing ionization of coupled bound exciton by energy carriers.

FIGS. 4A-4F show exemplary schematics illustrating the operation principle of cascaded exciton ionization in an exemplary solar cell device of the disclosed technology.

FIG. 5 shows an exemplary I-V characteristic plot showing the qualitative comparison of solar cell efficiency between a conventional Si single junction solar cell device and an exemplary solar cell device of the disclosed technology.

FIG. 6 shows an exemplary plot showing an exemplary result of the disclosed solar cell under red light illumination.

FIG. 7A and 7B show exemplary data plots of the measured wavelength dependence of responsivity and quantum efficiency of an exemplary solar cell device in a short-circuit configuration.

FIGS. 8A-8C show schematics of exemplary configurations of the device structure.

FIGS. 9A and 9B show images illustrating an exemplary nanowire based optical-to-electrical energy conversion device of the disclosed technology.

FIGS. 10A-10F show diagrams illustrating the operating principle of the exemplary optical-to-electrical energy conversion device of FIGS. 9A and 9B.

FIGS. 11A-11C show diagrams showing exciton formation and secondary e-h pair generation using the disclosed technology.

FIGS. 12A-12D show exemplary plots and diagrams of the characteristics of the exemplary nanowires of the disclosed technology.

FIGS. 13A-13C shows exemplary data plots of electrical characteristics of the exemplary nanowire device.

FIG. 14 shows an illustrative schematic of an exemplary carrier multiplication by cascaded exciton ionization process initiated from a single photon incident.

FIGS. 15A and 15B show data plots of the exemplary quantum efficiency as a function of the probability of the DAP excitation and ionization by hot electron or hole.

FIGS. 16A and 16B show exemplary noise analysis plots of an exemplary nanowire cascaded exciton ionization device.

FIGS. 17A and 17B show histogram plots of the exemplary quantum efficiency distribution.

DETAILED DESCRIPTION

Almost 95% of deployed solar cells in the world are crystalline Si single-junction solar cells. The Shockley-Queisser limit suggests that the single-junction Si (e.g., 1.1 eV bandgap) solar cell has a maximum theoretical efficiency of 29% (e.g., under 1.5 Sun). The efficiency limit is largely due to the energy loss to heat by photons having higher energy than the bandgap energy of silicon. To date, 25%-26% efficiency solar cells have been demonstrated. To push solar energy as an economically viable energy source, solar cell systems, devices, and processes need to drive significantly beyond low efficiencies, such as the 29% theoretical efficiency of single-junction Si solar cells while achieving a low cost approach.

Single junction solar cells refer to devices having their p/n junctions made of only one type of material (e.g. Si). In contrast, multi-junction solar cells are structured to contain a series of p/n junctions made of semiconductors of different bandgap energies. For example, a double-junction solar cell may include a GaAs p/n junction as the first p/n junction in series with a Ge p/n junction as the second p/n junction. Sunlight impinges upon the first GaAs p/n junction first and photons of greater energy than the GaAs bandgap energy are mostly absorbed. Photons of lower energy than the bandgap of GaAs are then absorbed by the second Ge p/n junction underneath the GaAs p/n junction. As such, multi-junction solar cells can obtain higher energy conversion efficiency at a higher cost than single junction silicon solar cells. A few applications such as space applications and designs involving solar concentrators as additional components may be able to take the technical advantage of the multi-junction solar cell designs for improved efficiencies. In most applications where the cost is a significant consideration, the vast majority of terrestrial solar cells are single junction, single crystal silicon solar cells with a bandgap energy of 1.12 eV.

The upper energy conversion efficiency of single junction silicon solar cells has been limited to 29% under 1.5 suns, as predicted by the Shockley-Queisser theory published in their 1961 paper. The theory has proven valid over the past 5 decades. The state-of-the-art single junction silicon solar cells demonstrated in the research laboratories have shown 25-26% efficiency and the devices deployed in the field has reached 20% efficiency. Decades of research has not produced effective and reproducible designs for single junction Si solar cells with efficiency above the Shockley-Queisser limit. For example, one important factor that limits the Si solar cell efficiency is the energy loss to phonons. When the photon energy is greater than the bandgap energy of Si, the extra energy turns into heat due to phonon scattering, causing more than 50% loss of solar energy. Also, for example, techniques such as multi-exciton generation (MEG) and secondary excitation have not proven to be effective or practical, and most nanostructure solar cells have shown even lower efficiency than optimized conventional devices.

Techniques, systems, and devices are described for highly-efficient optical to electrical energy conversion, e.g., which exceed the highest energy conversion efficiencies achievable for single-junction Si according to Shockley-Queisser theory.

The disclosed optical-to-electrical energy conversion technology provides practical, low cost methods to fundamentally overcome the Shockley-Queisser limit by a large margin. Exemplary methods of the disclosed technology can be applied to many types of semiconductors, including or besides silicon. In some aspects, for example, Si single junction solar cells devices are disclosed that achieve energy conversion efficiencies greater than 48%.

In one aspect, an optical-to-electrical energy conversion device of the disclosed technology is structured to include silicon core/shell nanostructures (e.g., nanowires) with heavily compensated p/n junctions to provide an optical region for optical-to-electrical energy conversion. The optical-to-electrical energy conversion device includes a substrate formed of a doped semiconductor material, in which the substrate includes a first region and a second region. The optical-to-electrical energy conversion device includes an array of multilayered nanostructures (e.g., such as nanowires) protruding from the first region of the substrate, in which the nanostructures (e.g., nanowires) are formed of a first co-doped semiconductor material covered by a layer of a second co-doped semiconductor material forming a core-shell structure, and in which the layer covers at least a portion of the doped semiconductor material of the substrate in the second region. The first and second co-doped semiconductor materials include electron acceptor dopants and electron donor dopants, in which the first co-doped semiconductor material is structured to include a greater concentration of one type of the acceptor or donor dopants than the other type dopants throughout the first co-doped semiconductor material, and the second co-doped semiconductor material is structured to include a greater concentration of the other type dopants than the one type dopants throughout the second co-doped semiconductor material. The optical-to-electrical energy conversion device includes an electrode formed on the layer-covered portion of the substrate in the second region. The multilayered nanostructures are structured to provide an optical active region capable of absorbing photons from light at one or more wavelengths (e.g., including visible light) to generate an electrical signal presented at the electrode.

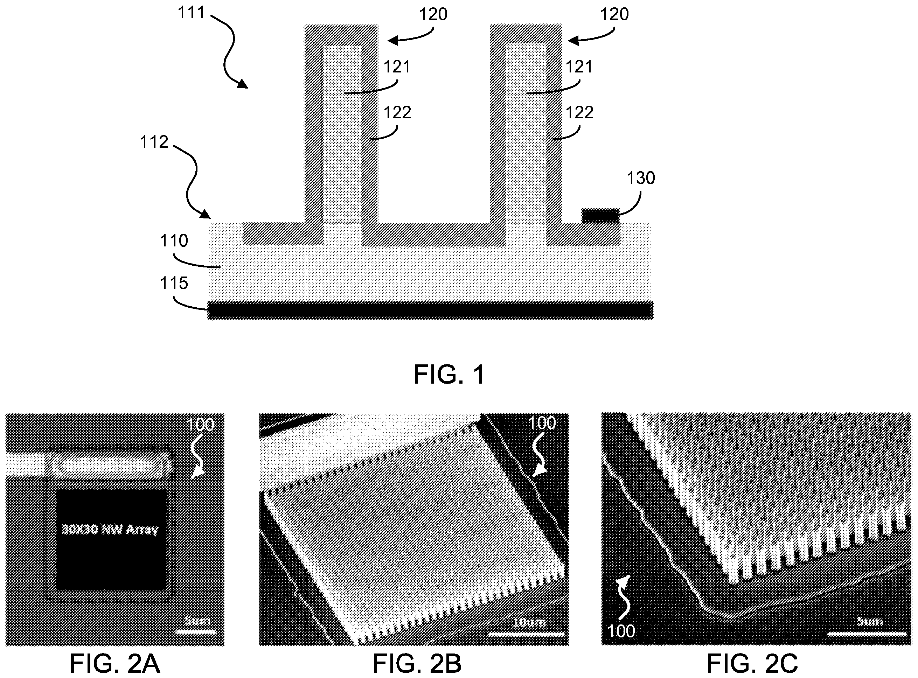

The exemplary solar cell device is shown in schematics and micrograph images of FIGS. 1 and 2A-2C, depicting etched nanowires and nano ridges standing vertically on the substrate of the device and having co-doped, heavily compensated $p^+/n^+$ junction with a narrow dimension in the direction of the $p^+/n^+$ junction.

FIG. 1 shows a schematic of a co-doped, heavily compensated p/n junction structure of an exemplary optical-to-electrical energy conversion device 100. In some implementations, for example, the device 100 can be used in a solar cell device. The device 100 includes a substrate 110 that is formed of a doped semiconductor material. For example, the substrate 110 can be configured as a p-type semiconductor, as in the exemplary embodiment shown in FIG. 1. In some implementations, for example, the device 100 can include a substrate base 115 formed of an electrical insulator material coupled to the substrate 110. The substrate 110 is structured to include two operative regions, a first region 111 and a second region 112. The first region 111 includes an array of multilayered nanowire structures 120 protruding from the substrate 110. The multilayered nanowire structures 120 are formed of a first co-doped semiconductor material 121 covered by a layer of a second co-doped semiconductor material 122, e.g., forming a core-shell structure. For example, in some implementations of the device 100, the first co-doped semiconductor material 121 can be engineered as a p+/n type semiconductor material, in which the p+/n type semiconductor material includes both electron acceptor and electron donor dopants throughout the first material, and the acceptor concentration is greater than the donor concentration (e.g., where the acceptor concentration can be on the order of $10^{19}$ cm$^{-3}$ carrier concentration and the donor concentration can be on the order of $10^{18}$ cm$^{-3}$ carrier concentration). In the present invention, the first co-doped semiconductor material 121 is controllably doped to a desired doping threshold to produce a co-doped, heavily compensated p+/n junction structure, in which the p+/n doping threshold is at least $10^{18}$ cm$^{-3}$. Also in such implementations, for example, the second co-doped semiconductor material 122 can be engineered as a n+/p type semiconductor material, in which the n+/p type semiconductor material includes both electron acceptor and electron donor dopants throughout the second material, and the donor concentration is greater than the acceptor concentration (e.g., where the donor concentration can be on the order of $10^{19}$ cm$^{-3}$ carrier concentration and the acceptor concentration can be on the order of $10^{18}$ cm$^{-3}$ carrier concentration). In the present invention, the second co-doped semiconductor material 122 is controllably doped to a desired doping threshold to produce a co-doped, heavily compensated n+/p junction structure, in which the n+/p doping threshold is at least $10^{18}$ cm$^{-3}$. In some implementations, for example, the layer of the second co-doped semiconductor material 122 can also cover at least a portion of the doped semiconductor material of the substrate 110 in the second region 112. The device 100 includes an electrode 130 formed on the layer-covered substrate in the second region. For example, the electrode 130 can be configured to include an n type semiconductor material. The multilayered nanowire structures 120 of the device 100 provide an optical active region capable of absorbing photons from visible light at particular wavelengths to generate an electrical signal presented at the electrode 130.

The optical-to-electrical energy conversion device 100 can be produced by the following fabrication method. The fabrication method can include a process to form an array of nanostructures (e.g., such as nanowires) in a first region (e.g., region 111) of a substrate formed of a doped semiconductor material (e.g., substrate 110). For example, the doping concentration of the substrate can be at least $10^{18}$ cm$^{-3}$ of a first dopant, e.g., in which the first dopant includes one type of electron acceptor dopants or electron donor dopants. The fabrication method can include a process to deposit a dopant material on the first region to form a layer over the array of nanostructures. For example, the dopant material contains a second dopant of the other type of the electron acceptor dopants or the electron donor dopants from the first dopant. For example, if the one type of dopants of the first dopant is electron acceptor dopants, then the other type of dopants of the second dopant is electron donor dopants. The fabrication method can include a process to (i) convert the doped semiconductor material of the array of nanostructures into a first co-doped semiconductor material having both the electron acceptor dopants and the electron donor dopants, in which there is a greater concentration of the one type of dopants than the other type of dopants. Concurrently, the fabrication method can include a process to (ii) convert the deposited material of the layer over the array of nanostructures into a second co-doped semiconductor material having both the electron acceptor dopants and the electron donor dopants, in which there is a greater concentration of the other type of dopants than the one type of dopants. For example, the converting process can include applying heat (e.g., at temperatures greater than 900 °C) for a duration of time (e.g., less than a minute) to control a diffusion process of the opposite dopants to diffuse throughout the primary doped materials (e.g., the doped semiconductor material of the nanostructures and the dopant material of the formed layer over the nanostructures) to form the first and the second co-doped semiconductor materials. Implementation of these processes of the fabrication method thereby produces a core/shell structure of the first co-doped semiconductor material and the second co-doped semiconductor material, respectively, capable of absorbing photons from light at one or more wavelengths to generate an electrical signal.

In some implementations of the fabrication method, the process to form the array of nanostructures can include etching the nanostructures from the substrate into a pattern based on a mask. For example, the etching can include an inductively coupled plasma-reactive-ion etching process with $C_4F_8$ and $SF_6$ gases using electron-beam lithographically-patterned nickel disks as the mask. In some implementations of the fabrication method, the process to deposit the dopant material can include coating a dopant solution onto a second substrate, baking the coated dopant solution on the second substrate, and transferring the second dopant from the second substrate on the first region of the substrate by applying heat to evaporate the second dopant to form the layer over the over the array of nanostructures. In some implementations of the fabrication method, the process to deposit the dopant material can include forming the layer to cover at least a portion of the doped semiconductor material of the substrate outside the first region. In some implementations, for example, the fabrication method can further include producing a contact pad of an electrically conductive material on the first region of the substrate.

FIGS. 2A-2C show exemplary optical and scanning electron micrographs of exemplary Si nanowire based optical-to-electrical energy conversion devices with the co-doped, heavily compensated p/n junction structure. The exemplary device 100 is shown in FIGS. 2A-2C structured to include an array of 30×30 p-core / n-shell silicon nanowire structures, e.g., having a nanowire diameter in a range of 280 nm to 340 nm. FIG. 2A shows exemplary optical of the device 100 with the exemplary co-doped, heavily compensated p/n junction structure. The exemplary scale bar in the optical image of FIG. 2A is 5 $\mu$m. FIGS. 2B and 2C show scanning electron microscopy (SEM) micrographs of the device 100 having the exemplary co-doped, heavily compensated p/n junction structure. The exemplary scale bar in the SEM micrograph of FIG. 2B is 10 $\mu$m, and the exemplary scale bar of the zoomed-in SEM micrograph of FIG. 2C is 5 $\mu$m.

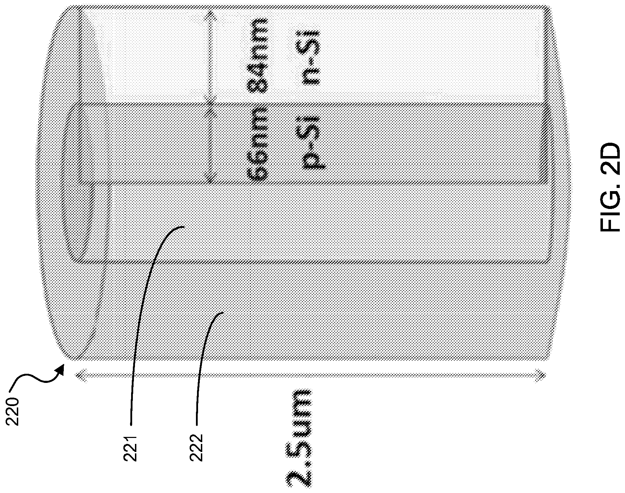

FIG. 2D shows a schematic of an exemplary co-doped p+/n+ junction nanowire structure 220 of an exemplary optical-to-electrical energy conversion device of the disclosed technology. In this example, a p-doped silicon (p-Si) material 221 is coated by an n-doped silicon (n-Si) material 222 to form a core-shell structure having a p+/n+ junction with a narrow dimension in the direction of the p$^+$/n$^+$ junction. For example, the p-Si material 221 can be configured in a cylindrical, wire-like structure, e.g., having a radius of ~66 nm, in which the n-Si material 222 can be formed in an outer cylindrical geometry encasing the p-Si material 221 and a thickness of ~84 nm, e.g., thereby producing the co-doped p+/n-type core n+/p-type silicon nanowire structure 220 to have a diameter of ~300 nm. In the example depicted in FIG. 2D, the interior core region of the co-doped junction nanowire structure 220 is formed of the p+/n type silicon material including both electron acceptor and electron donor dopants, in which the acceptor concentration is greater than the donor concentration. For example, the acceptor dopants can be on the order of $10^{19}$ cm$^{-3}$ (e.g., $2\times10^{19}$ cm$^{-3}$). The exterior shell region of the co-doped junction nanowire structure 220 is formed of the n+/p type silicon material including both electron acceptor and electron donor dopants, in which the donor concentration is greater than the acceptor concentration.

For example, the device 100 can be configured such that a high dosage of donors is introduced to the p-region and a high dosage of acceptors to the n-region, e.g., forming heavily compensated p/n junction. Through a process of "cascaded exciton ionization" (CEI), which occurs in such a heavily compensated device, under short-circuit conditions, the absorption of a single photon can produce multiple electron-hole pairs. For example, in the short-circuit condition, absorption of one photon can produce a large number (e.g. 4-10) of eh pairs. This then increases the short-circuit current by 400% to 1000%, e.g., as relative to state-of-the art devices. Consequently, a conversion efficiency higher than 29% can be achieved. For example, a conversion efficiency greater than 48% can be achieved in single-junction Si solar cells, thus nearly doubling the Shockley-Queisser limit.

For example, the optical active region is configured to absorb photons of visible light at wavelengths with energies above the 1.12 eV bandgap energy of Si. In some implementations of the device 100, for example, the optical active region is configured to absorb photons from visible light at 630 nm, in which the absorption of red photons at 630 nm wavelengths produce at least 4 electron-hole pairs for generation of the electrical signal.

Exemplary implementations of the disclosed optical-to-electrical energy conversion devices were performed. In some implementations, for example, photoresponse measurements were conducted under visible 630 nm light which showed that one 630 nm photon produces 4 to 10 electron-hole pairs under short-circuit conditions; and this exemplary result was reproducible. Within the exemplary CEI process of the disclosed technology, a hot carrier (e.g., ~ 1 eV kinetic energy) can ionize a bound exciton (A-D+) due to the high concentration of co-doped acceptors and donors. Loss of energy through phonon scattering is limited to ~50 meV given the nanoscale of the core/shell structure. There is no violation of energy conservation within the model, e.g., electron-hole generation occurs under short circuit conditions, and since the terminal voltage is zero, the device does not produce more output power than the input optical power.

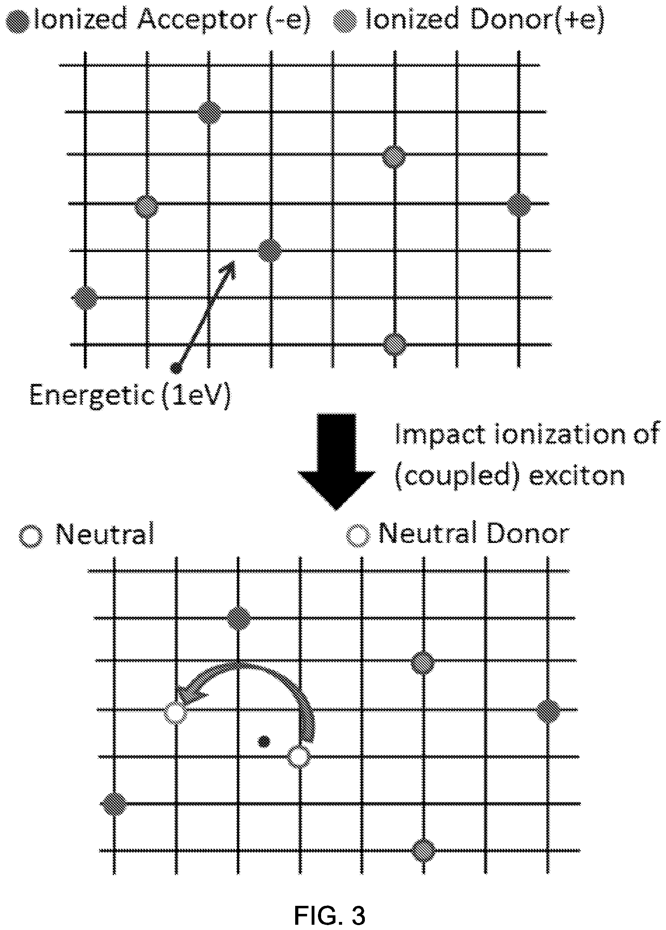

In some embodiments, the disclosed devices can be configured to include a large amount (~$10^{19}$ cm$^{-3}$) of acceptors and donors that are introduced into the semiconductor. In areas where the acceptor concentration is greater than the donor concentration, the material becomes p-type semiconductor. In areas where the donor concentration overcompensate for the acceptor concentration, the material shows the characteristics of n-type semiconductor. For example, because of the P$^+$/n$^+$ junction, the build-in potential is very close to the bandgap energy, e.g., around 1 eV for Si with its room temperature bandgap of around 1.12 eV. For example, because of co-existence of donors and acceptors in both p- and n- side of semiconductor, each side forms an impurity band and most important of all, a coupled 3D matrix of D+/A- bound excitons. The electrons move from the donors to occupy the states in the nearby acceptors, as shown in FIG. 3.

FIG. 3 shows exemplary diagrams showing ionization of coupled bound exciton by energy carriers. When both the donors and acceptors are doped to a level of the order of $1 \times 10^{19}$ cm$^{-3}$, for example, the average distance between a donor and an acceptor is less than 2.5 nm (e.g., around 2 nm). Depending on the carrier concentration, the Debye length is comparable to the donor-acceptor spacing. The exciton spacing is also less than the exciton radius (e.g., around 3 nm), causing coupled excitons. Thus, for example, it takes less than 1 eV to ionize the bound exciton to produce the neutral ($A^oD^o$) state. The neutral donor/acceptor is thermally ionized to become e/h pairs contributing to the current. For example, because of the core/shell nanostructure, a carrier can see the potential cliff at the p/n junction within an average distance of 40-60 nm. At a thermal velocity of $10^7$ cm/s, it may take about 0.5 ps to cross the potential cliff. Considering the energy relaxation time by phonon scattering, the carrier may lose less than 50 meV due to the inelastic phonon scattering. Considering the impurity band tails due to the heavy donor and acceptor concentrations, the energy required to "ionize an exciton" can be estimated to be approximately represented as Eg - $\varepsilon_d$ - $\varepsilon_a$ + |$\varepsilon_b$|, where $E_g$ is the bandgap of the bulk crystal, $\varepsilon_d$ and $\varepsilon_a$ are the ionization energy of donor and acceptor, and |$\varepsilon_b$| is the magnitude of excitonic binding energy. In practice, for example, the exciton ionization energy in such heavily co-doped and compensated semiconductor can be over 100 meV below the bandgap of bulk semiconductor. As to be discussed next, the lowering of the exciton ionization energy and the large number of coupled excitons present in such specific p/n junction structure is important to the high energy conversion efficiency of the solar cells.

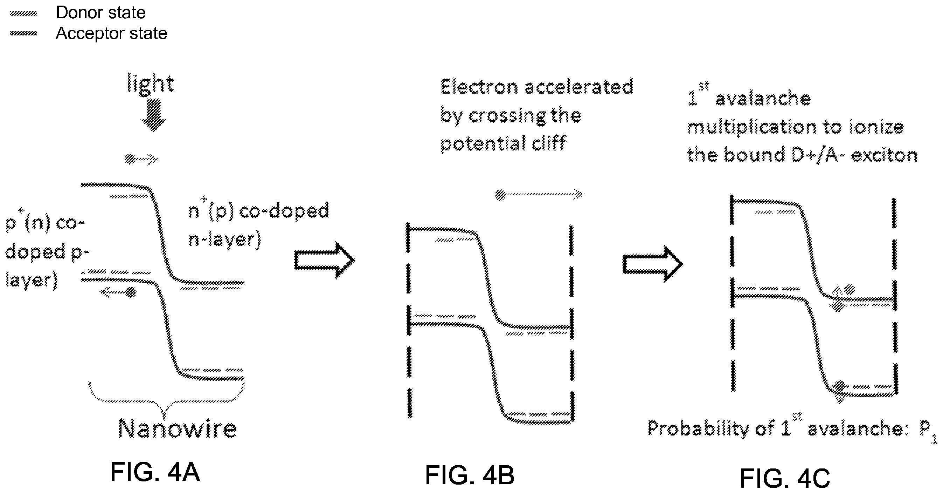

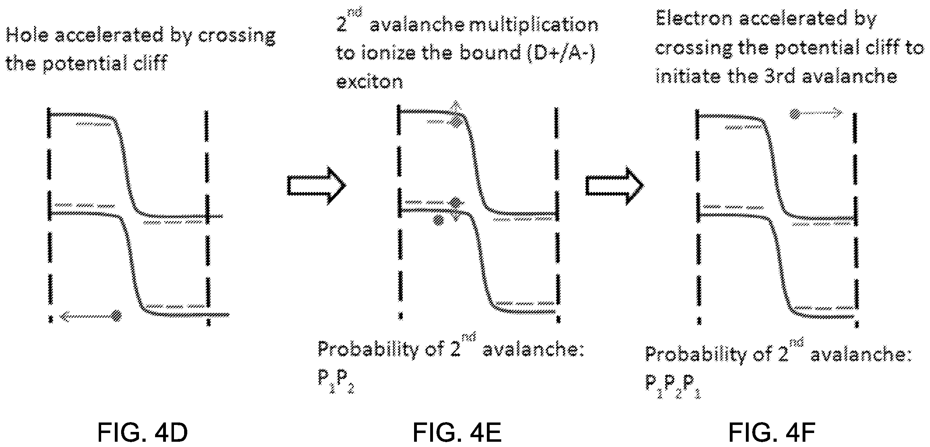

FIGS. 4A-4F show exemplary schematics illustrating the operation principle of the cascaded exciton ionization (CEI) in the exemplary optical-to-electrical energy conversion device 100 of the disclosed technology. For example, the disclosed optical-to-electrical energy conversion technology can produce multiple electron-hole pairs that contribute to the short-circuit current of solar cells. For example, assume a photon is absorbed in the p-side of the p/n junction to produce the primary electron-hole pair, as depicted in the plot of FIG. 4A, and the device 100 is connected in a short-circuit configuration. The photogenerated hole leaves the device rapidly, but the photo-generated electron crosses over a steep potential cliff and is accelerated to obtain a high kinetic energy of around 1 eV, as shown in FIG. 4B. In a normal p/n junction solar cell, the kinetic energy of the electron is quickly lost through phonon scattering and thermalized. However, due to the very high population of bound ($D^+/A^-$) excitons and the reduced exciton ionization energy explained previously, there exists a significant probability that the energetic electron ionizes an exciton to ($D°/A°$) state by collision, in a process similar to impact ionization. Before the ionized exciton has a chance to return to its original bound ($D^+/A^-$) state, it can be ionized by thermal energy or by interaction with other hot electrons to form a secondary electron-hole pair in the conduction and valence band, as depicted in FIG. 4C. The secondary hole will cross the p/n junction and gain the kinetic energy, shown in FIG. 4D. This energetic hole also has a finite probability to ionize a bound ($D^+/A^-$) to the ($D°/A°$) state on the p-side of the p/n junction, shown in FIG. 4E. The ($D°/A°$) state can be thermalized to produce the third generation of e-h pairs, as shown in FIG. 4F, and the process can go on.

In an exemplary model, the probability for electron initiated exciton ionization is $P_1$, and the probability for hole initiated exciton ionization is $P_2$. The average number of e-h pairs produced by absorption of a single photon can be represented as:

$$N = \frac{1+\frac{1}{2}(P_1+P_2)}{1-P_1P_2} \qquad (1)$$

N can be treated as the 'effective" quantum efficiency under the short-circuit condition. For example, if both $P_1$, $P_2$ = 0.5, N=2 according to Eq. 1, indicating that absorption of one photon can produce 2 electron-hole pairs and the short circuit current is twice of the incoming photon flux. The short-circuit current of the solar cell of the disclosed technology can be written as:

$$I_{sc} = I_{scc}\left[\frac{1+\frac{1}{2}(P_1+P_2)}{1-P_1P_2}\right] \qquad (2)$$

where $I_{sc}$ and $I_{scc}$ are the short-circuit current of the device of the disclosed technology and the conventional solar cell, respectively.

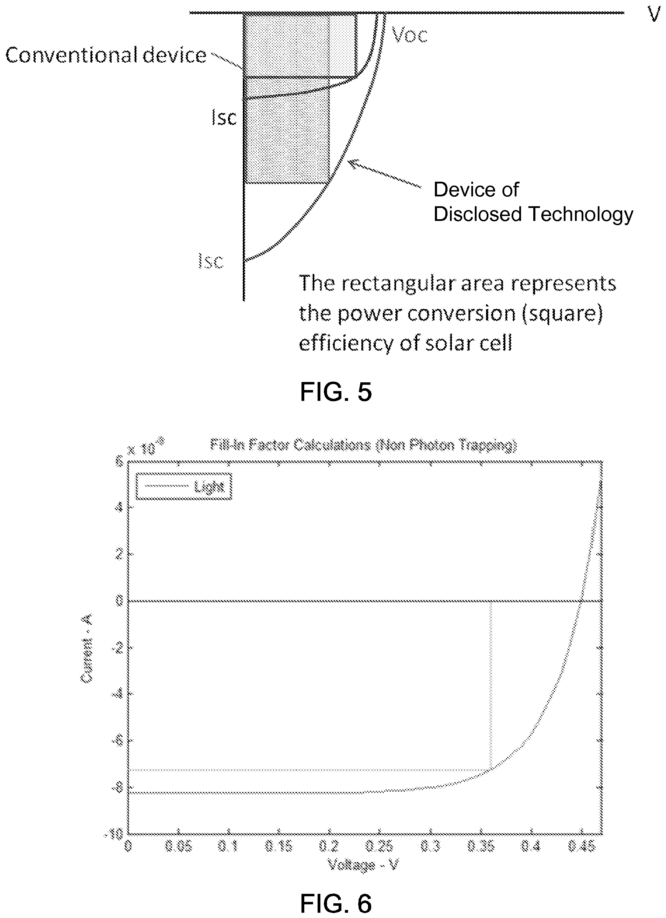

FIG. 5 shows an exemplary I-V characteristic plot showing the qualitative comparison of solar cell efficiency between a conventional Si single junction solar cell device and an exemplary solar cell device of the disclosed technology. The exemplary I-V characteristic plot of FIG. 5 shows qualitatively how an exemplary device of the disclosed technology, e.g., such as device 100, can enhance the overall solar cell efficiency. The device of the disclosed technology produces a significant increase in the short-circuit current, but only a modest effect on the open-circuit voltage. In the open circuit configuration, the accumulated electrons and holes on either side of the p/n junction reduces the magnitude of the potential cliff across the p/n junction by the amount of $V_{oc}$. As a result, the electrons and holes do not gain enough kinetic energy to produce excitons. When the probabilities of exciton ionization $P_1$, and $P_2$ approach zero, the device of the disclosed technology produces the same open-circuit voltage as conventional solar cells.

The net energy conversion efficiency of a solar cell is determined by the square efficiency, determined graphically by the largest rectangle within the area defined by the I-V characteristics under a given solar energy. It becomes apparent that when the short-circuit current increases, the square efficiency also increases. Or equivalently, the same amount of electrical power can be produced under weaker sun light.

FIG. 6 shows an exemplary plot showing an exemplary result of the disclosed solar cell under red light (e.g., 635 nm wavelength) illumination. The measured energy conversion efficiency was shown to be around 65% at the exemplary 635 nm wavelength. The exemplary result demonstrates the effect of cascaded exciton ionization (CEI). Otherwise, even in the most ideal scenario with 100% light capturing efficiency, zero Ohmic loss, and 100% quantum efficiency (i.e., every photon that is absorbed produces one e-h pair), the maximum achievable efficiency can only be 51% for 635 nm wavelength light.

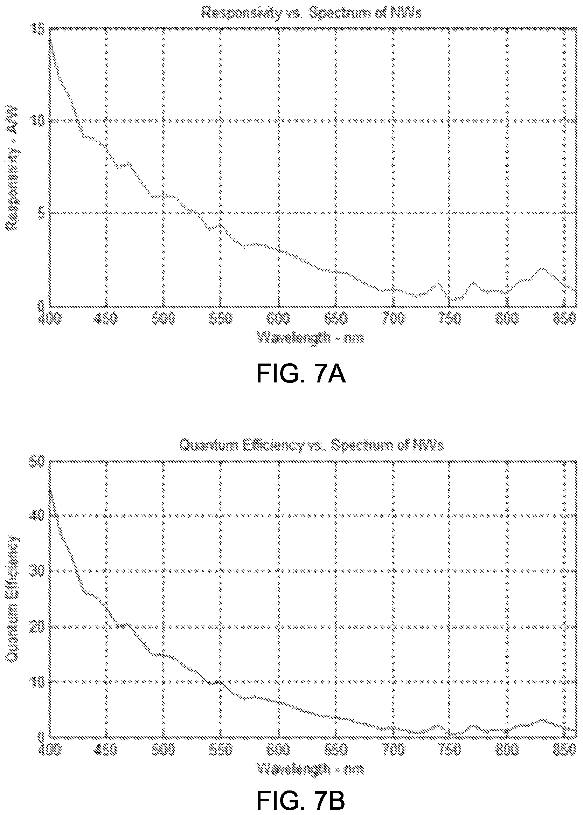

FIGS. 7A and 7B show exemplary data plots depicting the measured wavelength dependence of responsivity and quantum efficiency of an exemplary solar cell device in a short-circuit configuration, respectively, e.g., over the spectral range between 400 nm and 850 nm. As shown in FIG. 7B, at short wavelength (e.g., 400 nm), one single photon can produce over 40 electron-hole pairs contributing to the short-circuit current. It is noted that, for example, this does not violate the law of conservation of energy since the exemplary device is at zero bias, thus delivering no power in the short-circuit configuration. The contribution of power conversion efficiency from the significant increase in the short-circuit quantum efficiency is qualitatively illustrated in FIG. 5.

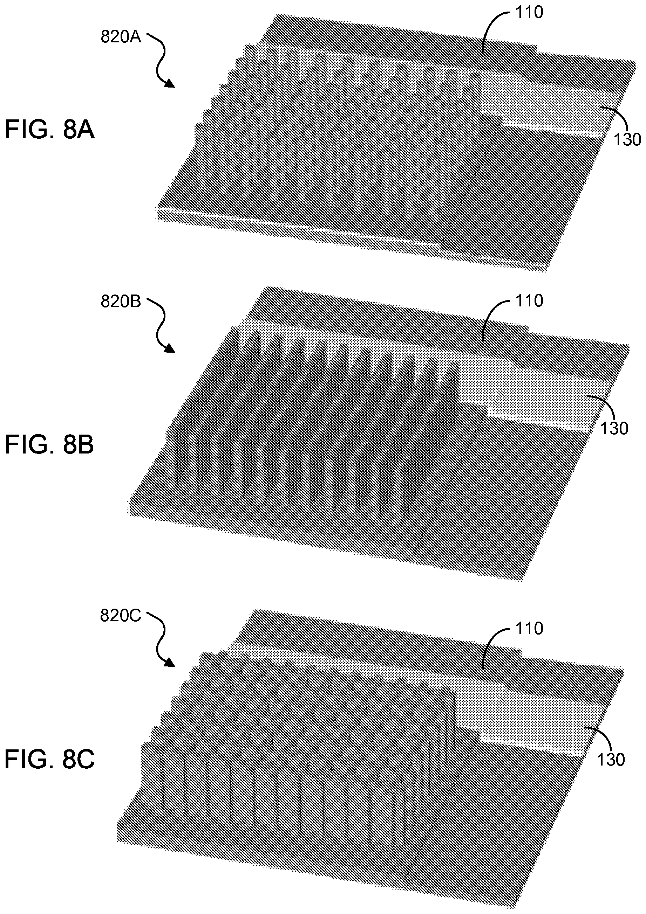

FIGS. 8A-8C show schematics of exemplary configurations of the disclosed device structure. In some exemplary embodiments, the optical-to-electrical energy conversion devices can be structured to include, but are not limited to, an array of nanoscale wires 820A shaped in a substantially cylindrical or conical geometry (e.g., 'nanowires'), as shown in FIG. 8A. In some exemplary embodiments, the optical-to-electrical energy conversion devices can be structured to include a linear array of nanoscale lines, ridges, or walls 820B having a substantially linear rectangular geometry (e.g., 'nanowalls'), as shown in FIG. 8B. In some exemplary embodiments, the optical-to-electrical energy conversion devices can be structured to include a crisscross of the nanowalls 820C, e.g., substantially perpendicular crisscrosses, similar to a waffle- or chessboard-like pattern (e.g., 'nanowaffles'), as shown in FIG. 8C. In all these exemplary structures, the cross section of the device has a co-doped, heavily compensated p/n junction similar to FIG. 1. Also, the nanoscale dimensions of the exemplary geometries include the diameters or widths of the multilayered nanostructures, while the height of such nanostructures protruding from the substrate can be configured in nanoscale dimensions, microscale dimensions, or greater.

In another aspect, devices, systems, and methods are described for optical to electrical signal conversion with high efficiency and low noise based on a cascaded exciton ionization (CEI) carrier multiplication mechanism. Exemplary CEI devices and methods can be implemented in a variety of applications including photovoltaics, communications, and imaging, among others.

Mechanisms of carrier multiplication can be used to increase the efficiency of optical to electrical signal and energy conversion, e.g., which can be implemented in applications including photovoltaics, communications, and imaging, among others. In some examples, multiple exciton generation (MEG) techniques have been used to create multiple carriers in low-dimensional semiconductors for photovoltaics. In some instances MEG can involve issues such as Auger recombination, material degradation, photocharing, and carrier trapping that limits its efficiency. For example, for optical detection, avalanche multiplication has been the primary mechanism for signal amplification for decades, but avalanche gain has its associated problems of excess noise, high operating voltage, and material dependence.

The disclosed techniques, systems, and devices include an engineered carrier multiplication mechanism, which is referred to as cascaded exciton ionization (CEI), e.g., using heavily compensated p+/n+ core-shell silicon nanowires. The disclosed CEI technology can be used to achieve high efficiency optoelectronic applications. For example, in some exemplary implementations described herein, due to the continuous excitation and ionization of donor-acceptor pair excitons initiated by photon absorption, the quantum efficiency is found to be substantially greater than 100% even under zero bias voltage.

The efficient conversion of light into electrical energy constitutes a key process in various optoelectronic applications such as communications, imaging, photovoltaics, and sensing. Using photovoltaics as an example, a prevailing idea of using excitonic effects to enhance efficiency is through multiple exciton generation (MEG). However, the strong competition of phonon scattering and Auger recombination has severely limited the multi-exciton generation efficiency, causing difficulties in realization of the concept in solar cells. Above all, for example, the MEG process may only occur to photons with energies at least twice the bandgap of the semiconductor material being used. For Si with a bandgap energy of 1.1 eV, photons with energy less than 2 eV cannot utilize the MEG effect to produce more than one e-h pair from absorption of a single photon. For optical detection, on the other hand, an internal gain mechanism, avalanche multiplication, can be been used in nanostructures to amplify the optical and exciton signals; however, the avalanche process requires high reverse bias and is unsuitable for photovoltaics and many low power applications.

Described herein are systems, devices, and techniques that apply an engineered physical mechanism, cascaded exciton ionization (CEI), to amplify the photoresponse of core-shell semiconductor nanoscale structures (e.g., silicon nanowires) without the constraint of the MEG or avalanche mechanism. An exemplary salient feature of the disclosed CEI technology is that, unlike avalanche multiplication, the CEI process can take place at low or even zero bias. As a result, the CEI process can be used for detection of optical signals and energy conversion such as photovoltaics, or even optical cooling (e.g., to remove heat from the area under illumination). In some implementations, for example, the disclosed CEI process can be implemented using a nanoscale device having a heavily-doped, partially compensated p-n junction in which the p-region contains a substantial amount of donors and the n-region contains a substantial amount of acceptors. Exemplary implementations of the disclosed CEI technology are described herein for applications in a core-shell Si nanowire structure. For example, partially-compensated p+/n+ core-shell junctions in the radial direction of the nanowires are created using a solid state diffusion process. For example, characterized are the nanowire internal gain resulted from the CEI by photocurrent measurements in the visible spectrum under zero bias. The exemplary results show that the quantum efficiency, in the short-circuit configuration, can be significantly greater than unity for photons of energy lower than 2 $E_g$ (e.g., 635 nm wavelength) at room temperature.

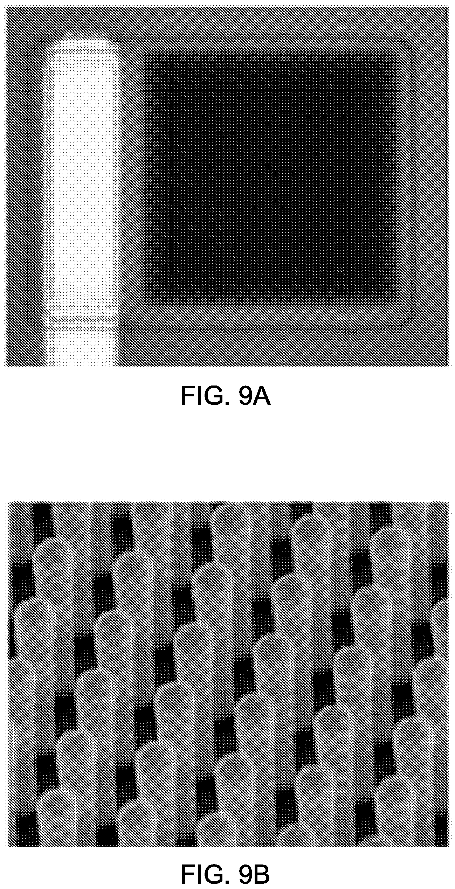

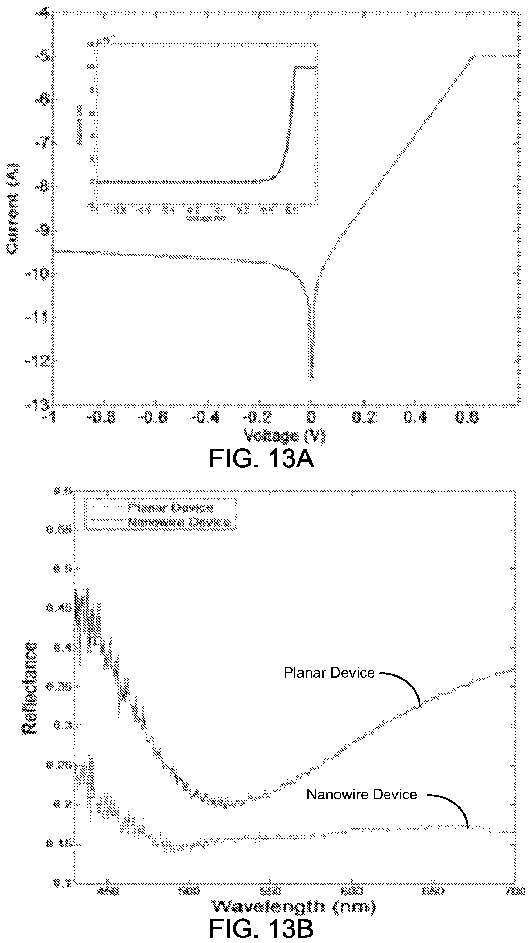

FIG. 9A shows an exemplary bright-field optical microscope image of an exemplary device of the disclosed technology containing an array of 30×30 vertical silicon nanowires with 1 μm pitch, fabricated on a 35 μm × 46 μm mesa. In this exemplary implementation, the nanowires are configured to have a radius of 340 nm and are 2.5 μm long. The nanowire array appears to be dark under microscope light as a result of the well-known photon trapping effect, which can also be confirmed by the reflection spectra measurements. A zoomed-in view of the SEM of the exemplary nanowire array device is also shown in FIG. 9B. The devices show typical p-n junction current-voltage characteristics with reverse bias current less than 0.5 nA at 1 V (as shown in FIG. 13A).

For example, the exemplary device shown in FIGS. 9A and 9B under illumination can be connected in a short-circuit configuration (at zero bias). Due to the co-existence of high concentrations of donors and acceptors in both sides of the radial p⁺/n⁺ junction of the silicon nanowires, a large number of donor-acceptor pairs (D⁺A⁻P) are present, providing the source for donor-acceptor pair exciton (DAP) formation. To elucidate the operating principle, it can be assumed that a photon with energy greater than the silicon bandgap is absorbed in the p-core and creates a primary electron-hole pair.

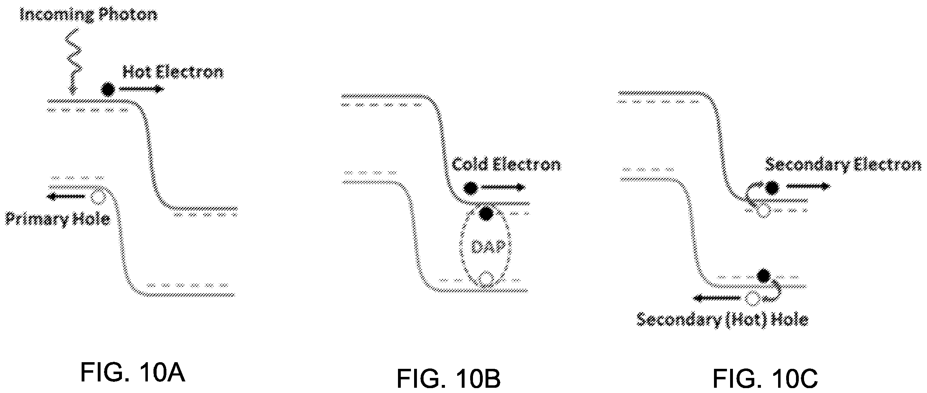

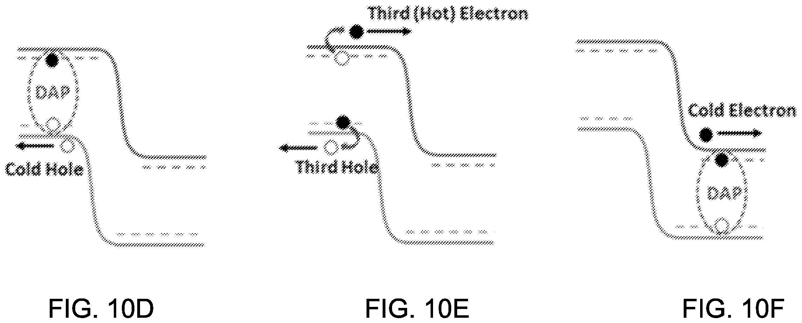

FIGS. 10A-10F show diagrams illustrating the exemplary operating principle of the exemplary nanowire device of the disclosed technology. FIG. 10A shows an exemplary diagram depicting primary electron-hole pair generation by photon absorption. The primary electron gains a high kinetic energy after crossing the potential cliff. FIG. 10B shows an exemplary diagram depicting the donor-acceptor pair exciton (DAP) formation by the hot electron which loses its energy after exciton excitation. FIG. 10C shows an exemplary diagram depicting the ionization of the donor-acceptor pair exciton (DAP) to create the secondary electron-hole pair. FIG. 10D shows an exemplary diagram depicting the DAP formation in the p-core by the secondary hot hole. FIG. 10E shows an exemplary diagram depicting the creation of the third generation of electron-hole pair by exciton ionization. FIG. 10F shows an exemplary diagram depicting the third-generation electron gains high kinetic energy to excite another DAP in the n-shell.

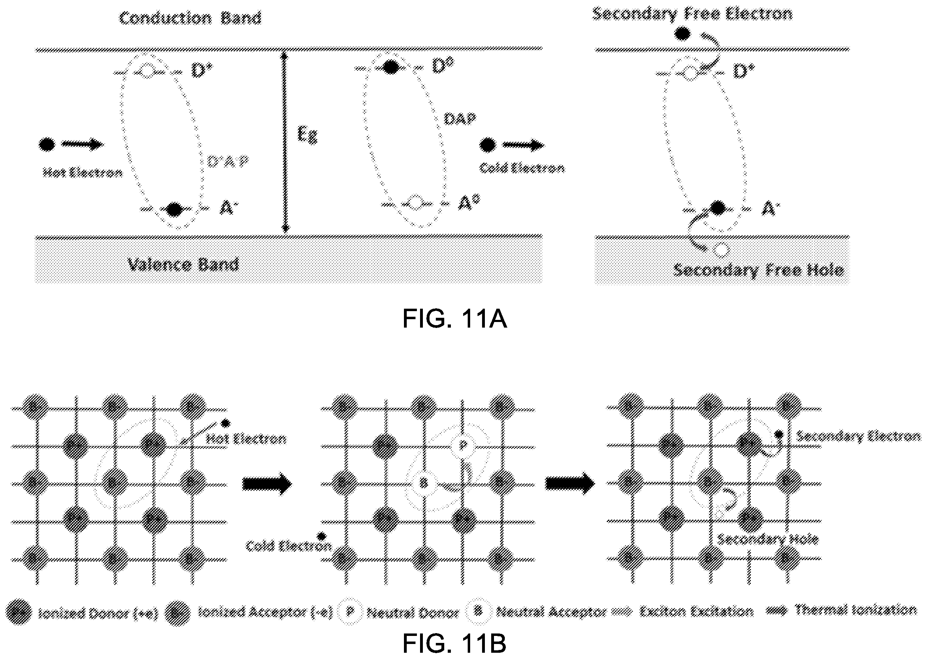

The primary hole leaves the device via the p-contact and the primary electron moves toward the n-shell (FIG. 10A). For a heavily doped p/n junction, the built-in potential is close to the bandgap energy and the depletion region is very thin (e.g., $L$ < 20 nm for a $10^{19}$ cm⁻³/ $10^{19}$ cm⁻³ p/n junction). As a result, for example, the photogenerated primary electron is accelerated within a short distance by the built-in potential to become a hot electron entering the n-shell. In a conventional p/n junction, the hot electron loses its energy and momentum via phonon emission or electron-electron scattering. However, in a heavily compensated p/n junction, the hot electron has a high probability to excite a donor-acceptor pair (D⁺A⁻P) into a donor-acceptor pair exciton (DAP), as illustrated schematically in FIG. 10B, and in FIGS. 11A and 11B for greater details. The energy required to excite a DAP exciton is given by $E = E_g - (E_a + E_d) + |E_b|$, where, for example, $E_a$ (0.044 eV) and $E_d$ (0.046 eV) are the impurity ionization energies for acceptors (boron) and donors (phosphorous), and $E_b$ is the binding energy of the exciton determined by the Coulomb interaction between the donor and acceptor ions. A simple model gives $E_b \sim e^2/4\pi\varepsilon R$, where e is the free electron charge, $\varepsilon$ is the dielectric constant of the material, and R is the exciton radius. For heavily compensated Si, for example, $E_b$ is on the order of 0.01 eV, thus yielding the required DAP excitation energy of around 1 eV from the above relation. Therefore, the hot electron possesses enough kinetic energy to excite a DAP exciton in the n-shell of the nanowire and this process can be expressed as:

$$D^+A^-P_{donor-acceptor\ pair} + e_{Hot} \rightarrow DAP_{exciton} + e_{Cold} \qquad (N1)$$

Following the exemplary process (N1), there exists two possible paths that the DAP exciton may take: (a) exciton annihilation by returning to the D⁺A⁻P state via radiative or non-radiative process:

$$DAP_{exciton} \rightarrow D^+A^-P_{donor-acceptor\ pair} + h\nu_{photon} \qquad \text{(N2-1)}$$

$$DAP_{exciton} + e_{Cold} \rightarrow D^+A^-P_{donor-acceptor\ pair} + e_{Hot} \qquad \text{(N2-2)}$$

or (b) thermal ionization to produce a free electron-hole pair:

$$DAP_{exciton} + E_{Phonon} \rightarrow e + h \qquad \text{(N3)}$$

Exemplary implementations of the disclosed technology show that the DAP exciton annihilation via photon emission, process (N2-1), occurs at very low temperatures; and process (N2-2) is relatively unlikely to happen unless for very low bandgap semiconductors having large Auger recombination coefficients. Thus, for silicon nanowires at room temperature, for example, the thermal ionization of DAP exciton, process (N3), is the predominant process, which is illustrated in FIGS. 11A-11C.

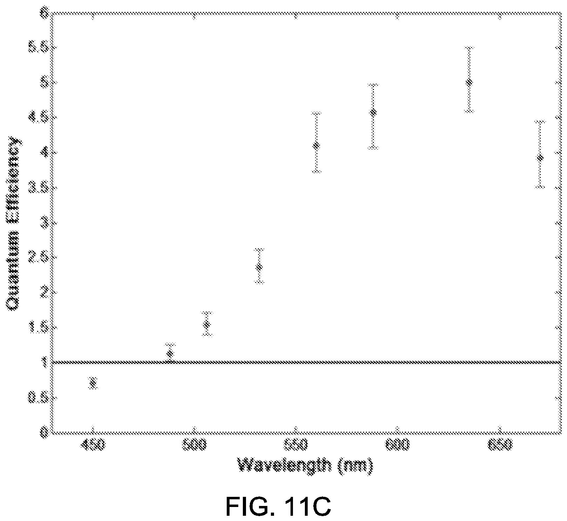

FIG. 11A shows an exemplary diagram showing exciton formation and thermal ionization initiated by a hot electron. FIG. 11B shows an exemplary diagram showing donor-acceptor pair exciton formation and thermal ionization illustrated in a crystal lattice. FIG. 11C shows an exemplary diagram showing quantum efficiency of nanowires obtained from direct measurements over wavelengths from 450 nm to 670 nm. The exemplary error bars show uncertainties of measured optical power impinging upon the nanowires.

The thermal ionization of DAP exciton creates the secondary free electron-hole pair by acquiring thermal energy from the crystal lattice (FIG. 10C) via phonons. The secondary electron in the conduction band leaves the device quickly via the n-contact. On the other hand, the secondary hole in the valence band acts in a similar manner to the primary electron: e.g., gaining high kinetic energy to generate a new DAP exciton by excitation of another $D^+A^-P$ (FIG. 10D) in the p-core. The disclosed exciton can again be thermally ionized to produce the third generation of free electron-hole pair and such process can take place in cascade between the p-core and the n-shell as illustrated in FIGS. 10A-10F. Similarly, carrier multiplication can also be initiated by a photon absorbed in the n-shell of the nanowire so that the primary hole becomes the particle that initiates the cascaded exciton generation and ionization process.

As illustrated in FIGS. 10A-10F, the exemplary device operating principle suggests that one can achieve quantum efficiency that is significantly greater than unity in the short-circuit configuration. The quantum efficiency (e.g., the total number of electron-hole pairs generated from a single photon) can be expressed analytically as:

$$\langle \eta \rangle = [F_c(1 + x_0) + F_s(1 + y_0)] + \left[ \frac{F_c x_0 y(1+x) + F_s y_0 x(1+y)}{1-xy} \right] \qquad \text{(N4)}$$

where $F_c$ and $F_s$ are the probability for the photon to be absorbed in the p-core and n-shell, and $x_0$ ($y_0$) is the probability for the primary electron (hole) to excite the secondary e-h pair. On the other hand, $x$ ($y$) represents the probability for the secondary and all future generations of electrons (holes) to excite e-h pairs ($0 \leq x,y \leq 1$). For example, a distinction can be made for the probability of the primary electron (hole) and the probability of future generations of electrons (holes) because the primary electrons (holes) are produced by direct photon absorption, e.g., thus attaining different characteristics than all other electrons (holes) in terms of their energies and positions. The most apparent difference is that the values of $x_0$ and $y_0$ are expected to be wavelength dependent whereas the values of $x$ and y are supposed to be wavelength independent. The wavelength dependence of $x_0$ and $y_0$ could also be due to the location where the photon is absorbed, in the core or in the shell. For the e-h pair generated in the shell, the value of probability may also depend on its distance from the surface of the exemplary nanostructure (e.g., such as the nanowire), being affected by the surface recombination via surface states.

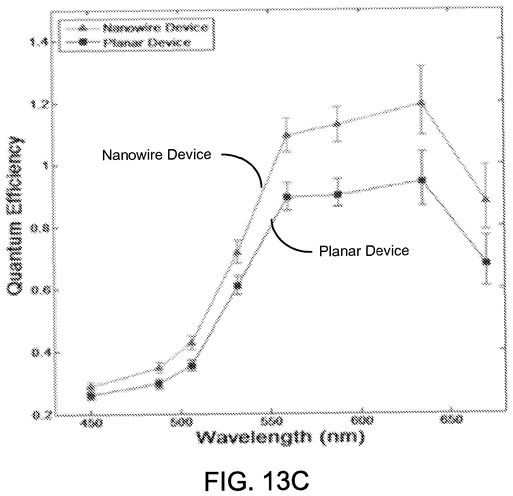

In the exemplary implementations of the disclosed CEI technology, for example, an optical monochromator setup was used to measure the effect of cascaded exciton ionization in the heavily compensated $p^+/n^+$ core-shell nanowire. Optical excitations above the bandgap of silicon (e.g., 450 nm - 670 nm) were used to measure the photoresponse of an exemplary device in a short-circuit configuration. The exemplary device was measured at zero bias to eliminate the possibility for other carrier amplification mechanisms and to remove measurement errors due to any leakage current. The amount of light at each wavelength impinging upon the nanowires was corrected from reflection of the non-polarized, normal incident light (FIG. 13B). Both an exemplary arrayed nanowire device of the disclosed technology and a planar device (without nanowires) were characterized in the same manner (FIG. 13C). Following the exemplary steps described later this patent document, the quantum efficiency of nanowires was obtained, as plotted in FIG. 11C based on the geometry differences between the nanowire and the planar device. For example, the quantum efficiency (QE) was found to be greater than unity for wavelengths longer than 488 nm. However, optical diffraction and evanescent coupling effects can trap photons within the nanowire array. Therefore, for example, the QE values presented in FIG. 11C include contributions from both the photon trapping effect and the CEI effect.

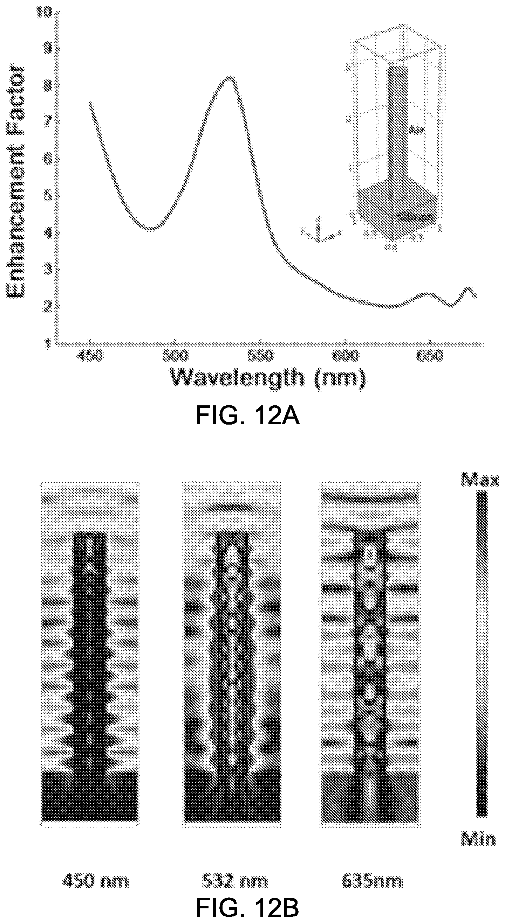

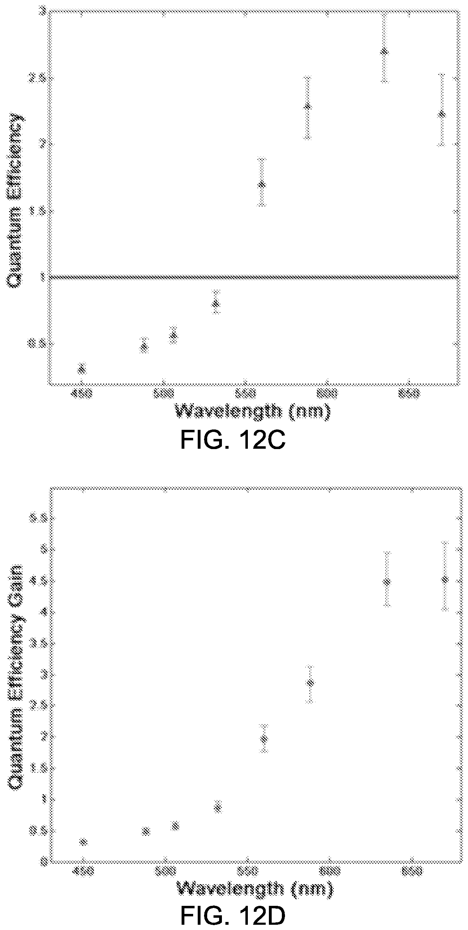

To obtain the contribution from the photon trapping effect, for example, exemplary implementations were performed using three-dimensional finite element method (FEM) simulations to study the corresponding electromagnetic field distribution within the nanowire array, as shown in FIGS. 12A-12B. FIG. 12A shows a data plot of the absorption enhancement factor over the physical fill factor due to the photon trapping effect in the main panel and, in the inset, an exemplary diagram of a vertical nanowire structure used for finite element method (FEM) simulations. FIG. 12B shows an exemplary diagram of the major transverse electric field ($|E_y|$) distribution in the y-z plane for the nanowire array at three representative wavelengths - 450 nm, 532 nm, and 635 nm. FIG. 12C shows an exemplary data plot of the quantum efficiency of nanowires originated from the cascaded exciton ionization effect alone after removing the contribution of the photon trapping effect. FIG. 12D shows an exemplary data plot of the cascaded exciton ionization (CEI) gain in core-shell silicon nanowires.

For example, in the exemplary implementations using the three-dimensional FEM simulations, an infinite array of 340 nm diameter, 2.5 $\mu$m long silicon NWs was used in the simulations with a periodic boundary of 1 $\mu$m × 1 $\mu$m square. For example, since the exemplary device was radially symmetric, linearly polarized light (polarized in the y-direction, $E_y$) was used and incident normal to the top surface of the exemplary device. Complex wavelength dependent refractive indices for Si were used for the nanowires and $n$ = 1 for air was used for the space between the nanowires, as illustrated in the inset of FIG. 12A. According to the exemplary simulations, both the power absorbed by the Si nanowires ($P_{Nw}$) and the power absorbed by the bottom Si planar area between the nanowires ($P_{planar}$) was calculated. The enhancement factor $E.\ F.$ due to the photon trapping effect is defined as $E.\ F. = P_{NW}/(P_{Total} \times F.F.)$, where $F.\ F.$ is the geometric fill factor being equal to $\pi \times (0.17)^2/1^2 = 0.0908$ for nanowires with a diameter of 340 nm in the square array with 1 $\mu$m pitch, and $P_{Total}$ (= $P_{NW} + P_{Planar}$) is the total absorbed optical power. Within the measured spectrum, two highest photon trapping enhancement factors were found at 450 nm and 532 nm, respectively (as shown in FIG. 12A).

The diagram of FIG. 12B presents the distribution of the major transverse electric field ($|E_y|$) in the y-z plane where most of the electric field resides at three representative wavelengths, e.g., 450 nm, 532 nm, and 635 nm. For example, the significance of the field distribution is elucidated later in this patent document when wavelength dependent quantum efficiency originated from the CEI effect is discussed. For example, the true contribution from the cascaded exciton ionization (CEI) effect to the quantum efficiency can be calculated according to the equation:

$$\eta_{NW} = (\eta_{NWM} - \eta_{PlanarM}) \times \frac{1}{F.F. \times E.F.} + \eta_{PlanarM} \qquad (N5)$$

where $\eta_{NW}$ is the true quantum efficiency of nanowires, $\eta_{PlanarM}$ is the measured quantum efficiency of the planar device, and $\eta_{NWM}$ is the measured quantum efficiency of the exemplary arrayed nanowire device (FIG. 13C). As defined previously, $F.F.$ and $E.\ F.$ are the geometric fill factor and the enhancement factor due to photon trapping effect. The product $F.\ F. \times E.\ F.$ can thus be considered as the "effective fill factor" of the nanowires. The calibrated values of $\eta_{NW}$ for different wavelengths are shown in FIG. 12C. Note that the quantum efficiency is over 100% for wavelengths longer than 560 nm with the highest QE to be around 270% at 635 nm. This is an exemplary demonstration of carrier multiplication due to the effect of the disclosed cascaded exciton ionization (CEI) technology for optoelectronic amplification that can occur at zero bias condition.

Further obtained, for example, was the cascaded exciton ionization gain, e.g., by taking the ratio of $\eta_{NW}$ of nanowires and the light absorption of silicon $\eta_{Int}$ ($\eta_{Int}$ = 1-$e^{-\alpha L}$, where $\alpha$ is the wavelength dependent absorption coefficient of silicon, and $L$ is the thickness of silicon and equals to 2.5 um). The cascaded exciton ionization (CEI) gain is shown in FIG. 12D. The exemplary device shows the highest gain of around 4.5 and saturates at 635 nm.

For example, the reduced CEI gain at shorter wavelength may be attributed to the surface recombination effect. For example, at 450 nm, as shown in FIG. 12B, the electromagnetic field is concentrated at the air/nanowire interface so most photogenerated carriers are produced near the surface of nanowires, experiencing a high surface recombination rate via the surface states. This yields a low value of $y_0$ in Eq. (N4) and lowers the quantum efficiency. In contrast, for example, at 635 nm wavelength the photon energy is distributed more evenly with a significant fraction of light being in the core of nanowire. As a result, many carriers produced by 635 nm light are located in the core of the nanowire, being distant from the surface states and experiencing much less surface recombination effect than those carriers produced by 450 nm light. This can explain the different values of CEI gain at different wavelengths. For example, by understanding the role of surface recombination in CEI gain, one can conceive different device geometries and apply surface passivation techniques to raise the CEI gain at shorter wavelengths for optimal device performance.

As described in the exemplary embodiments and demonstrated in the exemplary implementations, the disclosed CEI techniques, systems, and devices including heavily compensated $p^+/n^+$ core-shell silicon nanostructures can be utilized to achieve >100% quantum efficiency. The donor-acceptor pairs in the compensated regions provide the sources for exciton formation. These excitons can be subsequently ionized by phonon scattering, producing free electron-hole pairs contributing to photocurrent. The disclosed CEI technology provides avenues to creating multiple electron-hole pairs from a single photon to enhance the efficiency of optical to electrical energy conversion. For example, the CEI effect can be applied to many other materials such as compound semiconductors and polymers besides silicon.

The exemplary implementations described herein included the following exemplary methods.

Exemplary Device Fabrication Methods

The exemplary devices shown in FIGS. 9A and 9B were fabricated on a boron-doped p+ silicon substrate (doping concentration $\sim2\times10^{19}$ cm$^{-3}$). The nanowires were etched by inductively coupled plasma - reactive-ion etching (ICP-RIE) process with $C_4F_8$ and $SF_6$ gases having electron-beam lithographically patterned nickel disks as mask. After nanowire formation, the nickel mask was removed using Ni etchant. To prepare a source for n-dopant, phosphorous-containing spin-on-dopant (SOD) solution (Filmtronics, Inc.) was spun on a separate silicon wafer. After baking at 200 °C for 15 min, the SOD-coated wafer was placed about 1 mm above the wafer with nanowires in a rapid thermal annealing (RTA) furnace. The phosphorous diffusion process was performed inside the RTA furnace at 950 °C for about 40 seconds when phosphorous evaporated from the SOD layer and are diffused into the nanowires, converting $p^+$-Si near the nanowire surfaces into n-shells. At the same time, the phosphorous diffusion tail penetrated the $p^+$-core, thus forming a heavily compensated $p^+/n^+$ core/shell nanowires required for the cascaded exciton ionization process. To reduce the contact resistance of nanowires, another run of RTA annealing process was performed without the SOD-coated wafer. Mesas ($\sim$ 350 nm high) were etched to isolate nanowire arrays, followed by the deposition of a $SiO_2$ layer ($\sim$265 nm). Finally, a Ti/Au (50/200 nm) contact pad was deposited to form the top n-contact, and the p-contact shared by all the devices was formed on the back of the silicon substrate.

Exemplary Optical Measurements (e.g., at room temperature)

The exemplary silicon nanowire devices of the disclosed technology and planar devices were optically excited using a home-built optical monochromator with a 600 g/mm grating. A fiber bundled halogen lamp was used as the light source. The full width at half maximum (FWHM) of each specific wavelength was 10 nm, verified by the measurement using a spectrum analyzer (Ocean Optics HR-2000). After transmitting through a series of optical elements, the light (with a spot size larger than the size of the device) was perpendicularly directed to the top of the device. The power of the incoming light was measured with a calibrated power meter (Newport 1830-C). The light intensity profile and the total optical power impinging upon the sample were measured using a calibrated detector and an X-Y translational stage. The exemplary device was connected in a short-circuit configuration with no bias applied between the two contacts, and the photocurrent was measured using a semiconductor parameter analyzer (Agilent 4155-B). Finally, the quantum efficiency of each device was calculated taking into account reflections at the nanowire-air interface.

Exemplary Device Characterization and Reflection Spectroscopy Measurements

FIG. 13A shows, in the main panel, a data plot of the exemplary electrical characteristics (e.g., semilogarithmic plot) of the nanowire device in the absence of light illumination; and in the inset, a linear plot of the current-voltage characteristics. FIG. 13B shows an exemplary data plot of the reflection spectroscopy of both the nanowire and the planar devices. For example, as a function of incident light wavelength, the reflection of the nanowire device is always significantly smaller than that of the planar device, an indicative of the photon trapping effect. FIG. 13C shows a plot of the exemplary quantum efficiencies of the exemplary arrayed nanowire device and the exemplary planar device.

FIG. 13A shows the dark I-V characteristics of the nanowire device used in this exemplary characterization implementation. The exemplary device shows the rectifying behavior of typical p-n junctions.

Reflection spectroscopy has been utilized to determine the amount of light actually entering the device instead of being reflected or scattered. The exemplary nanowire device contains a square nanowire array (30 $\times$ 30) with a pitch of 1 $\mu$m. The exemplary nanowire array was situated on a 35 $\mu$m $\times$ 46 $\mu$m silicon mesa. The incident light used for reflection spectrum measurement was focused onto the center of the nanowire array with a beam spot of around 10 $\mu$m in diameter. Also measured was the reflection spectrum of the planar device using the same experimental setup. The reflection spectra at different wavelengths are shown in FIG. 13B. The lower reflection from the nanowire device suggests the photon trapping effect occurs to the nanowire array. A spectra dip at around 525 nm is consistent with the calculated resonance in FIG. 12A.

Based on the data from the reflection measurements, the photoresponsivities of both the nanowire device and the planar device can be obtained since the accurate amount of light power that is absorbed can be found. FIG. 13C shows the wavelength dependent QE values for both the nanowire device and the planar device.

Since the exemplary nanowire device also contains planar area over the mesa, the net photoresponse includes the response from the nanowires and from the planar area. Further used is the following procedure to obtain the true nanowire photoresponse from the data in FIG. 13C. Defined is $P$ as the total absorbed optical power, $R_{NW}$ as the responsivity of nanowires to find, $R_{PlanarM}$ as the measured responsivity of the planar device, and $R_{NWM}$ as the measured responsivity of the NW device that contains nanowires and planar areas. Other useful parameters include: *F.F.*: fill factor of nanowires and *E. F.* - enhancement factor at specific wavelengths due to the photon trapping effect. The following relations can thus be applied to extract the photoresponse of nanowires:

$$R_{NWM}P = R_{NW}P(F.F.\times E.F) + R_{PlanarM}P[1 - (F.F.\times E.F)] \qquad (\text{NS-1})$$

The responsivity of nanowires can be expressed as:

$$R_{NW} = (R_{NWM} - R_{PlanarM}) \times \frac{1}{F.F.\times E.F} + R_{PlanarM} \qquad (\text{NS-2})$$

Using the relation $\eta_{NW} = h\nu/qR_{NW}$, the quantum efficiency of nanowires can be extracted and is shown in FIG. 12C.

Derivation of Quantum Efficiency from the Cascaded Exciton Ionization (Eq. (N4))

In the following, the analytical expression of the quantum efficiency due to the cascaded exciton ionization effect is derived.

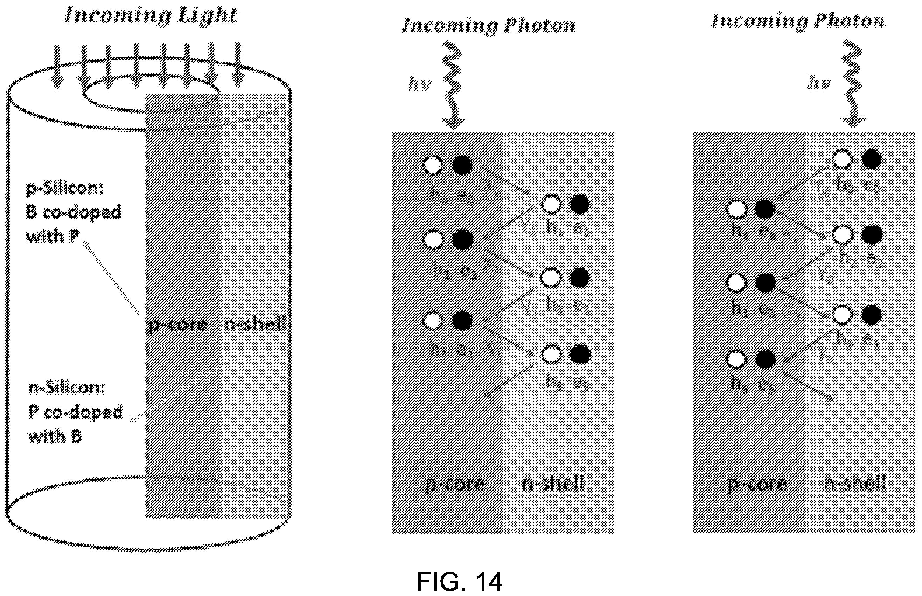

FIG. 14 shows an illustrative schematic of an exemplary carrier multiplication by cascaded exciton ionization process initiated from a single photon incident either on the p-core or on the n-shell. The schematic of FIG. 14 shows how the photogenerated primary electron-hole pair initiates the cascaded ionization process. In FIG. 14, each electron and hole is labelled according to their history of generation. For example, "0" is used to denote the primary electron and hole generated by photon absorption. The probability that the $i_{th}$ hot electron/hole can create another free electron-hole pair is defined as $X_i/Y_i$.

The value of $X_i/Y_i$ is between 0 and land obey the following relations:

$$X_i = x \ (i = 1,2,3, ...) \qquad (\text{NS-3})$$

$$Y_i = y \ (i = 1,2,3, ...) \qquad (\text{NS-4})$$

On the other hand, $X_0/Y_0$ represents the probability that the primary free electron/hole excites the secondary free e-h pair. Since the primary free electron/hole is generated from photon absorption, different from the future generations of free electrons/holes, their values may depend on the incoming photon energy, the position of light absorption, etc. Thus, the total number of electron-hole pairs produced from the absorption of a photon in the p-core can be expressed as:

$$\eta_{core} = F_c[1 + X_o + X_oY_1 + X_oY_1X_2 + X_oY_1X_2Y_3 + X_oY_1X_2Y_3X_4 + \cdots] \qquad (\text{NS-5})$$

where $F_c$ is the probability of the incoming photon absorbed in the p-core. Using the relations in (NS-3) and (NS-4), one can simplify (NS-5) into:

$$\eta_{core} = F_c[(1 + x_0) + \frac{x_oy(1+x)}{1-xy}] \qquad (\text{NS-6})$$

Similarly, the total number of e-h pairs due to the absorption of a single photon in the n-shell can be expressed as:

$$\eta_{shell} = F_s[1 + Y_o + Y_oX_1 + Y_oX_1Y_2 + Y_oX_1Y_2X_3 + Y_oX_1Y_2X_3Y_4 + \cdots] \qquad (\text{NS-7})$$

where $F_s$ is the probability of the photon absorbed in the n-shell. Again, using the relations in (NS-3) and (NS-4), obtained is:

$$\eta_{shell} = F_s[(1 + y_0) + \frac{y_ox(1+y)}{1-xy}] \qquad (\text{NS-8})$$

Finally, the total quantum efficiency can be written as:

$$\eta = \eta_{core} + \eta_{shell} = [F_c(1 + x_0) + F_s(1 + y_0)] + \left[\frac{F_c x_0 y(1+x) + F_s y_0 x(1+y)}{1-xy}\right] \quad \text{(NS-9)}$$

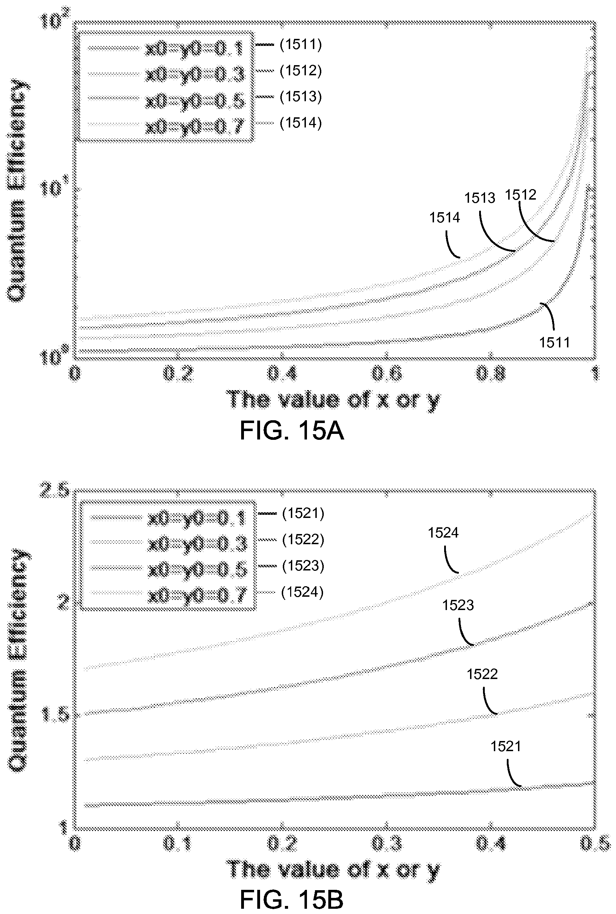

Assuming $F_c = F_s$ = 0.5 (equal probability for light to be absorbed in the core and shell area), plotted is the CEI quantum efficiency in FIG. 15A and 15B as a function of $x$ and $y$ using $x_o$ and $y_o$ as parameters. For simplicity, further assumed is $x$ = y and $x_o = y_o$ in the calculations.

FIGS. 15A and 15B show data plots of the exemplary quantum efficiency as a function of the probability of the DAP excitation and ionization by hot electron or hole. The data plot of FIG. 15A shows a semi-log scale plot with the value of $x/y$ varying from 0 to 1, when $x_0$=$y_0$=0.1 (waveform 1511), $x_0$=$y_0$=0.3 (waveform 1512), $x_0$=$y_0$=0.5 (waveform 1513), and $x_0$=$y_0$=0.7 (waveform 1514). The data plot of FIG. 15B shows a linear scale plot with the value of $x/y$ varying from 0 to 0.5, when $x_0$=$y_0$=0.1 (waveform 1521), $x_0$=$y_0$=0.3 (waveform 1522), $x_0$=$y_0$=0.5 (waveform 1523), and $x_0$=$y_0$=0.7 (waveform 1524).

The disclosed devices, systems, and techniques can be implemented for signal amplification using the new CEI physical mechanism. The CEI effect of the disclosed technology occurs at much lower applied voltage than avalanche process. Also, quite importantly, it produces extremely low excess noise. Excess noise is the limiting factor for the achievable sensitivity for any signal detection systems, and is the noise associated with the gain. An exemplary analytical model is elucidated herein to calculate the excess noise resulted from an exemplary CEI effect, and the exemplary result is also verified by the Monte Carlo simulations.

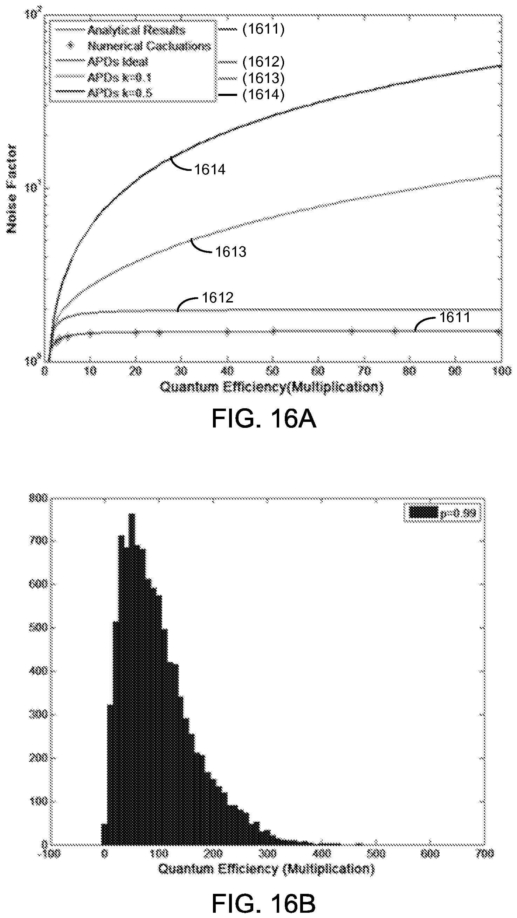

FIGS. 16A and 16B show exemplary noise analysis plots of an exemplary nanowire cascaded exciton ionization device. The plot of FIG. 16A shows the excess noise factor as a function of the quantum efficiency (multiplication) of the exemplary nanowire CEI device calculated by the exemplary analytical model (red, plot 1611) and Monte Carlo simulation (star '*' symbols). The excess noise factor vs. avalanche multiplication with different hole/electron ionization ratios is also plotted in FIG. 16A. For example, the green curve 1612 (k=0) depicts the characteristics of "ideal" avalanche detector, which can be referred to the 'quantum limit" of avalanche multiplication. For example, the pink curve 1613 (k=0.1) and the black curve 1614 (k=0.5) depict the characteristics of avalanche detectors with different ratios of ionization coefficients.

FIG. 16A shows the dependence of the excess noise factor on the multiplication factor produced by the CEI effect and avalanche multiplication with different ratios of ionization coefficients (e.g., k = $\alpha_p/\alpha_n$ = 0, 0.1 and 0.5.). For example, as shown in the data plot, the excess noise factor from the CEI effect is well below that of the avalanche mechanism, and is even lower than the quantum limit of "ideal" avalanche detectors (i.e., k=0). The exemplary results suggest that photoreceivers based on the CEI effect can potentially achieve higher sensitivity than conventional avalanche photodetector (APD) receivers. The exemplary nanowire CEI device generates an excess noise factor lower than 2, the theoretical limit of an "ideal APD" that does not in fact exist in a real world.

FIG. 16B shows an exemplary Monte Carlo simulated histogram of CEI gain distribution under the mean multiplication value of 100. For example, exemplary Monte Carlo simulations were carried out to verify the analytical model and to produce histograms of CEI gain distribution. As shown in the exemplary plot of FIG. 16B, the Monte Carlo simulated distribution of CEI multiplication assuming the mean value of the CEI gain was 100. The exemplary results show a much tighter gain distribution than avalanche multiplication.

Any amplification process will introduce excess noise and there is no exception for the cascaded exciton ionization effect. In the following, an analytical model of the excess noise for the CEI device is developed. Using Eq. (NS-5) as an example, the quantum efficiency in the core region can be re-written as:

$$\eta_{core} = 1 + X_o + X_o Y_1 + X_o Y_1 X_2 + X_o Y_1 X_2 Y_3 + X_o Y_1 X_2 Y_3 X_4 + \cdots$$

$$= (1 + X_0) + X_0 Y_1 \left[\sum_{i=1}^{}(1 + X_{2i}) \prod_{k=1}^{i-1} X_{2k} Y_{(2k+1)}\right] \quad \text{(NS-10)}$$

Note that Eq. (NS-10) is a random variable. To calculate the excess noise, both the mean and the variation of the random variable need to be calculated. The mean of $\eta_{core}$ can be written as:

$$\langle\eta_{core}\rangle = 1 + x_0 + (1 + x) + (1 + x)xy + (1 + x)x^2 y^2 + \cdots$$

$$= 1 + x_0 + \frac{(1+x)}{1-xy} \quad \text{(NS-11)}$$

For example, using the relations: $< (1 + X_0)X_0Y_1 >= 2x_0y$ and $< (1 + X_0)^2 >= 1 + 3x_0$, one further has:

$$\langle \eta_{core}{}^2 \rangle == 1 + 3x_0 + \frac{4x_0y(1+x)}{1-xy} + I_1 + I_2 \tag{NS-12}$$

where:

$$I_1 = x_o y \langle \sum_{i=1}(1 + X_{2i})^2 \prod_{k=1}^{i-1} \prod_{l=1}^{i-1} X_{2l}Y_{(2l+1)} X_{2k}Y_{(2k+1)} \rangle$$

$$= x_o y \langle \sum_{i=1}(1 + X_{2i})^2 (X_2^2 Y_3^2)(X_4^2 Y_5^2) \dots \left( X_{2(i-1)}^2 Y_{2i-1}^2 \right) \rangle$$

$$= x_o y(1 + 3x)\left[\sum_{i=1}(xy)^{i-1}\right] = x_o y \frac{(1+3x)}{1-xy} \tag{NS-13}$$

and where:

$$I_2 = x_o y \langle \sum_i \sum_{j \neq i}(1 + X_{2j})(1 + X_{2i}) \prod_{k=1}^{i-1} \prod_{l=1}^{j-1} X_{2l}Y_{(2l+1)} X_{2k}Y_{(2k+1)} \rangle \tag{NS-14}$$

One can divide $I_2$ into two components $I_2 = I_{21} + I_{22}$ :

$$I_{21} = x_o y \langle \sum_{i=1} \sum_{j=1}^{j=i-1}(1 + X_{2j})(1 + X_{2i}) \prod_{k=1}^{i-1} \prod_{l=1}^{j-1} X_{2l}Y_{(2l+1)} X_{2k}Y_{(2k+1)} \rangle \tag{NS-15}$$

$$I_{22} = x_o y \langle \sum_{i=1} \sum_{j=i+1}(1 + X_{2j})(1 + X_{2i}) \prod_{k=1}^{i-1} \prod_{l=1}^{j-1} X_{2l}Y_{(2l+1)} X_{2k}Y_{(2k+1)} \rangle \tag{NS-16}$$

where, $I_{21}$ includes all terms in the double summation where $j < i$, and $I_{22}$ includes all terms in the double summation where $i < j$. Since the index i and j play an equal role, $I_{21}$ is equal

to $I_{22}$. $I_{21} = x_o y \langle \sum_{i=1} \sum_{j=1}^{j=i-1}(1 + X_{2j})(1 + X_{2i}) \prod_{k=1}^{i-1} \prod_{l=1}^{j-1} X_{2l}Y_{(2l+1)} X_{2k}Y_{(2k+1)} \rangle$

$$= x_o y \langle \{(1 + X_4)(1 + X_2)X_2Y_3 + (1 + X_6)[(1 + X_4)X_2{}^2Y_3{}^2X_4Y_5 + (1 +$$

$$X_2)X_2Y_3X_4Y_5] + (1 + X_8)[(1 + X_6)X_2{}^2Y_3{}^2X_4{}^2Y_5{}^2X_6Y_7 + (1 + X_4)X_2{}^2Y_3{}^2X_4Y_5X_6Y_7 +$$

$$(1 + X_2)X_2Y_3X_4Y_5X_6Y_7] + \cdots \} \rangle \qquad = 2x_o y(1 + x)\{xy + 2x^2y^2 + 3x^3y^3 + \cdots\}$$

$$= 2x_o y \frac{(1+x)xy}{(1-xy)^2} \tag{NS-17}$$

As a result, one has:

$$I_2 = I_{21} + I_{22} = 2I_{21} = 4x_o y \frac{(1+x)xy}{(1-xy)^2} \tag{NS-18}$$

From Eqs. (12), (13) and (18), one can obtain:

$$\langle \eta_{core}^2 \rangle = 1 + 3x_0 + \frac{x_0y(5+7x)}{1-xy} + 4x_o y \frac{(1+x)xy}{(1-xy)^2} \tag{NS-19}$$

Similarly, in the shell region one can have:

$$\langle \eta_{shell}^2 \rangle = 1 + 3y_0 + \frac{y_0 x(5+7y)}{1-xy} + 4y_o x \frac{(1+y)xy}{(1-xy)^2} \qquad \text{(NS-20)}$$

Also,

$$\langle \eta_{core} \rangle^2 = [(1 + x_0) + \frac{x_o y(1+x)}{1-xy}]^2 \qquad \text{(NS-21)}$$

$$\langle \eta_{shell} \rangle^2 = [(1 + y_0) + \frac{y_o x(1+y)}{1-xy}]^2 \qquad \text{(NS-22)}$$

$$\langle \eta \rangle = [P_C(1 + x_0) + P_S(1 + y_0)] + \left[ \frac{P_C x_o y(1+x) + P_S y_o x(1+y)}{1-xy} \right] \qquad \text{(NS-23)}$$

$$\langle \eta^2 \rangle = \langle \eta_{core}^2 \rangle + \langle \eta_{shell}^2 \rangle + 2\langle \eta_{core} \rangle \langle \eta_{shell} \rangle \qquad \text{(NS-24)}$$

From Eqs. (NS-19 - NS-24), the excess noise factor associated with the CEI multiplication process can be calculated analytically, for example:

$$F = \frac{\langle \eta^2 \rangle}{\langle \eta \rangle^2} = 1 + \frac{[\langle \eta_{core}^2 \rangle - \langle \eta_{core} \rangle^2] + [\langle \eta_{shell}^2 \rangle - \langle \eta_{shell} \rangle^2]}{(\langle \eta_{core} \rangle + \langle \eta_{shell} \rangle)^2} \qquad \text{(NS-25)}$$

To verify the exemplary analytical model, exemplary Monte Carlo simulations were performed, e.g., using Eq. (NS-26), where all $X_i$'s and $Y_i$'s are treated as independent random variables with possible values of 0 or 1 with assigned probabilities. For example, a total number of 10,000 trials were used to obtain the mean value of quantum efficiency (multiplication) and the noise factor.

$$\eta = P_C\left\{(1 + X_0) + X_0 Y_1 \left[ \sum_{i=1}(1 + X_{2i}) \prod_{k=1}^{i-1} X_{2k} Y_{(2k+1)} \right] \right\}$$
$$+ P_S\left\{(1 + Y_0) + Y_0 X_1 \left[ \sum_{j=1}(1 + Y_{2j}) \prod_{l=1}^{j-1} Y_{2l} X_{(2l+1)} \right] \right\} \qquad \text{(NS-26)}$$

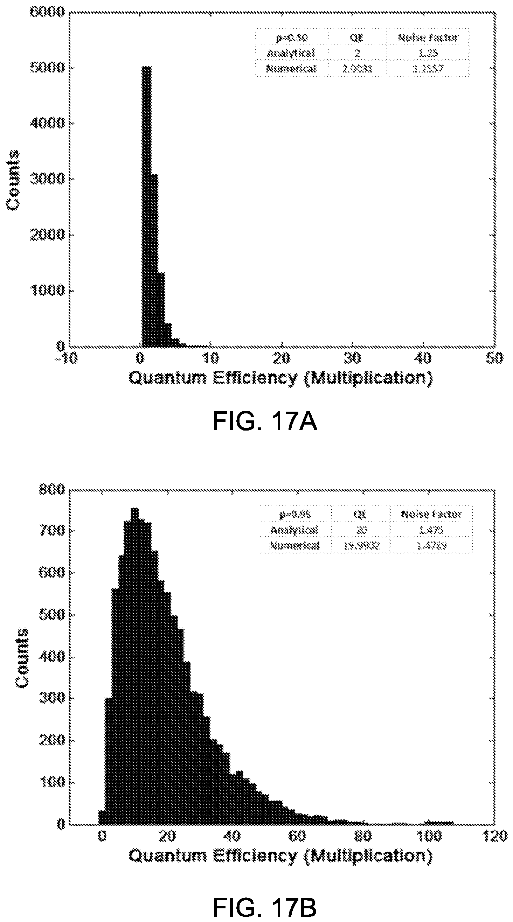

FIGS. 17A and 17B show histogram plots of the exemplary quantum efficiency distribution with the e-h pair generation probability of p = 0.5 (FIG. 17A) and p = 0.95 (FIG. 17B), e.g., corresponding to the mean value of quantum efficiency (multiplication) of 2.0 and 20.0, respectively. As shown in the histograms of FIGS. 17A and 17B, the quantum efficiency distribution is shown with the mean value of $X_i$ ($Y_i$). Both the average gain and the spread of the gain increase with the mean value of $X_i$ ($Y_i$). The exemplary simulation results showed excellent agreements with the exemplary results from the analytical model.

## Claims

1. An optical-to-electrical energy conversion device, comprising:

    a substrate (110) formed of a doped semiconductor material, the substrate (110) including a first region (111) and a second region (112);
    an array of multilayered nanostructures (120) protruding from the first region (111) of the substrate (110), wherein the multilayered nanostructures (120) are formed of a first co-doped semiconductor materia (121) covered by a layer of a second co-doped semiconductor material (122) forming a core-shell structure, the layer (122) covering at least a portion of the doped semiconductor material of the substrate (110) in the second region (112), wherein the first and second co-doped semiconductor materials (121, 122) include electron acceptor dopants and electron donor dopants, in which the first co-doped semiconductor material (121) includes a greater concentration of one type of the acceptor or donor dopants than the other type dopants, and the second co-doped semiconductor material (122) includes a greater concentration of the other type dopants than the one type dopants,

wherein the first and the second co-doped semiconductor material (121, 122) include the acceptor and donor dopants at a concentration level of at least $1 \times 10^{18}$ cm$^{-3}$ to provide co-doped, heavily compensated junction structures; and

an electrode (130) formed on the layer-covered portion of the substrate in the second region,

wherein the multilayered nanostructures (120) are structured to provide an optical active region capable of absorbing photons from light at one or more wavelengths to generate an electrical signal presented at the electrode (130).

2. The device of claim 1, wherein said substrate comprises a first dopant, which includes one type of electron acceptor dopant or electron donor dopant.

3. The device of claim 1, wherein the doped semiconductor material includes p-type silicon.

4. The device of claim 1, further comprising: a substrate base coupled on the side of the substrate opposite that of the array of multilayered nanoscale structures and formed of an electrical insulator material.

5. The device of claim 1, wherein the first co-doped semiconductor material includes a p+/n type semiconductor material, the p+/n type semiconductor including both electron acceptor and electron donor dopants, in which the acceptor concentration is greater than the donor concentration; and/or wherein the second co-doped semiconductor material includes a n+/p type semiconductor material, the n+/p type semiconductor material including both electron acceptor and electron donor dopants, in which the donor concentration is greater than the acceptor concentration.

6. The device of claim 1, wherein the first and the second co-doped semiconductor material includes dopants at a concentration level substantially on the order of $1 \times 10^{19}$ cm$^{-3}$.

7. The device of claim 1, wherein the one or more wavelengths includes 630 nm wavelength, and absorption of a red photon at the 630 nm wavelength produces at least 4 electron-hole pairs to generate to the electrical signal; and/or wherein the one or more wavelengths includes wavelengths of visible light with energies above the 1.12 eV bandgap energy of Si.

8. The device of claim 1, wherein the array of multilayered nanostructures are structured to have a geometry including one or more of a wire-like structure, a wall-like structure, or a wafflelike structure.

9. The device of claim 7, wherein the array of multilayered nanostructures include nanowires having a diameter of substantially 300 nm and a height of substantially 2500 nm.

10. The device of claim 1, wherein the device generates an excess noise factor that is below 2.0.

11. A method to convert optical energy to electrical energy, comprising:

providing an optical-to-electrical energy conversion device according to claim 1;
illuminating a surface of said optical-to-electrical energy conversion device
generating an electrical signal from the light obtained by said optical-to-energy conversion via a cascaded exciton ionization mechanism at the array of multilayered nanostructures, wherein the electrical signal is presented at the electrode (130) formed on the layer-covered portion of the substrate in the second region; and
providing the generated electrical signal to an electrical circuit.

12. The method of claim 11, wherein the light includes one or more wavelengths including a 630 nm wavelength, and wherein the generating the electrical signal from the light at the 630 nm wavelength produces at least 4 electron-hole pairs to generate to the electrical signal.

13. The method of claim 11, wherein:

the first co-doped silicon material includes a p+/n type silicon material including both electron acceptor and electron donor dopants, in which the acceptor concentration is greater than the donor concentration, and the second co-doped silicon material includes a n+/p type silicon material including both electron acceptor and electron donor dopants, in which the donor concentration is greater than the acceptor concentration.

14. The method of claim 11, wherein the array of multilayered nanostructures include a geometry of nanowire structures, nanowall structures, or nanowaffle structure.

15. The method of claim 11, wherein the light includes sunlight and the electrical circuit is included in a device at least partially powered by the optical energy converted to the electrical energy by the method.

16. The method of claim 11, wherein the electrical signal exhibits an excess noise factor that is below 2.0.


**Patentansprüche**

1. Vorrichtung zur Umwandlung von optischer in elektrische Energie, umfassend:

   ein Substrat (110), das aus einem dotierten Halbleitermaterial gebildet ist, wobei das Substrat (110) einen ersten Bereich (111) und einen zweiten Bereich (112) beinhaltet;
   eine Anordnung mehrschichtiger Nanostrukturen (120), die aus dem ersten Bereich (111) des Substrats (110) herausragt, wobei die mehrschichtigen Nanostrukturen (120) aus einer ersten co-dotierten Halbleitermaterial (121) gebildet sind, die von einer Schicht aus einem zweiten co-dotierten Halbleitermaterial (122) bedeckt sind, die eine Kern-Schale-Struktur bildet, wobei die Schicht (122) mindestens einen Teil des dotierten Halbleitermaterials des Substrats (110) in dem zweiten Bereich (122) bedeckt,
   wobei die ersten und die zweiten co-dotierte Halbleitermaterialien (121, 122) Elektronenakzeptor-Dotierstoffe und Elektronendonator-Dotierstoffe beinhalten, in denen das erste co-dotierten Halbleitermaterial (121) eine größere Konzentration von einer Sorte von den Elektronenakzeptor- oder Elektronendonator-Dotierstoffe als die andere Sorte Dotierstoffe beinhaltet, und das zweite co-dotierten Halbleitermaterial (122) eine größere Konzentration von der anderen Sorte Dotierstoffe als die erste Sorte Dotierstoffe beinhaltet,
   wobei das erste und das zweite co-dotierte Halbleitermaterial (121, 122) die Akzeptor- und Donator-Dotierstoffe in einem Konzentrationsniveau von mindestens $1 \times 10^{18}$ cm$^{-3}$ beinhalten, um eine co-dotierte, stark kompensierte Übergangsstruktur zu schafften, und
   eine Elektrode (130), die auf dem schichtbedeckten Bereich des Substrats in dem zweiten Bereich gebildet ist, wobei die mehrschichtigen Nanostrukturen (120) so strukturiert sind, dass sie einen optisch aktiven Bereich bereitstellen, der im Stande ist Photonen von Licht mit einer oder mehreren Wellenlängen zu absorbieren, um ein elektrisches Signal zu erzeugen, das an der Elektrode (130) präsentiert wird.

2. Die Vorrichtung nach Anspruch 1, wobei genanntes Substrat einen ersten Dotierstoff von einer Sorte der Elektronenakzeptor-Dotierstoff und Elektronendonator-Dotierstoff beinhaltet.

3. Die Vorrichtung nach Anspruch 1, wobei das dotierte Halbleitermaterial Silizium vom p-Typ beinhaltet.

4. Die Vorrichtung nach Anspruch 1, ferner umfassend: eine Substratbasis, die auf der Seite des Substrats gegenüber der Anordnung der mehrschichtigen nanoskaligen Strukturen gekoppelt ist und aus einem elektrischen Isolatormaterial gebildet ist.

5. Die Vorrichtung nach Anspruch 1, wobei das erste co-dotierte Halbleitermaterial ein Halbleitermaterial vom p+/n-Typ umfasst, wobei der Halbleiter vom p+/n-Typ sowohl Elektronenakzeptor- als auch Elektronendonator-Dotierstoffe beinhaltet, bei denen die Akzeptorkonzentration größer als die Donorkonzentration ist; und/oder wobei das zweite co-dotierte Halbleitermaterial ein Halbleitermaterial vom n+/p-Typ beinhaltet, wobei das Halbleitermaterial vom n+/p-Typ sowohl Elektronenakzeptor- als auch Elektronendonator-Dotierstoffe beinhaltet, bei denen die Donatorkonzentration größer als die Akzeptorkonzentration ist.

6. Die Vorrichtung nach Anspruch 1, wobei das erste und das zweite co-dotierte Halbleitermaterial Dotierstoffe in einem Konzentrationsniveau im Wesentlichen in der Größenordnung $1 \times 10^{19}$ cm$^{-3}$ beinhaltet.

7. Die Vorrichtung nach Anspruch 1, wobei die eine oder mehreren Wellenlängen eine Wellenlänge von 630 nm umfassen und die Absorption eines roten Photons bei der Wellenlänge von 630 nm mindestens 4 Elektron-Loch-Paare erzeugt, um das elektrische Signal zu erzeugen; und/oder wobei die eine oder mehreren Wellenlängen Wellenlängen von sichtbarem Licht mit Energien oberhalb der 1,12 eV Bandlückenenergie von Si umfassen.

8. Die Vorrichtung nach Anspruch 1, wobei die Anordnung von mehrschichtigen Nanostrukturen so strukturiert ist, dass sie eine Geometrie aufweisen, die eine oder mehrere einer drahtartigen Struktur, einer wandartigen Struktur oder einer waffelartigen Struktur umfasst.

9. Die Vorrichtung nach Anspruch 7, wobei die Anordnung von mehrschichtigen Nanostrukturen Nanodrähte mit einem Durchmesser von im Wesentlichen 300 nm und einer Höhe von im Wesentlichen 2500 nm umfasst.

10. Die Vorrichtung nach Anspruch 1, wobei die Vorrichtung einen übermäßigen Rauschfaktor erzeugt, der unter 2,0 liegt.

11. Verfahren zur Umwandlung von optischer Energie in elektrische Energie, umfassend:

Bereitstellen einer Vorrichtung zur Umwandlung von optischer in elektrische Energie nach Anspruch 1;
Beleuchten einer Oberfläche der genannten Vorrichtung zur Umwandlung von optischer in elektrische Energie,
Erzeugen eines elektrischen Signals durch das Licht, das durch genannte Vorrichtung zur Umwandlung von optischer in elektrische Energie via einen kaskadierten Exzitonenionisation-Mechanismus an der Anordnung von mehrschichtigen Nanostrukturen erhalten wurde, wobei das elektrische Signal an der Elektrode (130), die auf dem schichtbedeckten Bereich des Substrats in dem zweiten Bereich gebildet ist, präsentiert wird;
Bereitstellen des erzeugten Signals an einen Stromkreis.

12. Das Verfahren nach Anspruch 11, wobei das Licht eine oder mehrere Wellenlängen einschließlich einer Wellenlänge von 630 nm beinhaltet und wobei das Erzeugen des elektrischen Signals von dem Licht bei der Wellenlänge von 630 nm mindestens 4 Elektron-Loch-Paare erzeugt, um das elektrische Signal zu erzeugen.

13. Das Verfahren nach Anspruch 11, wobei:

Das erste co-dotierte Siliciummaterial ein Siliciummaterial vom p+/n-Typ beinhaltet, dass sowohl Elektronenakzeptor- als auch Elektronendonor-Dotierstoffe beinhaltet, wobei die Akzeptorkonzentration größer als die Donorkonzentration ist, und
das zweite co-dotierte Siliciummaterial ein n+/p-Typ Siliziummaterial beinhaltet, dass sowohl Elektronenakzeptor- als auch Elektronendonor-Dotierstoffe beinhaltet, bei denen die Donorkonzentration größer als die Akzeptorkonzentration ist.

14. Das Verfahren nach Anspruch 11, wobei die Anordnung von mehrschichtigen Nanostrukturen eine Geometrie von Nanodrahtstrukturen, Nanowandstrukturen oder Nanowaffelstrukturen umfasst.

15. Das Verfahren nach Anspruch 11, wobei das Licht Sonnenlicht beinhaltet und der Stromkreis in einer Vorrichtung enthalten ist, die zumindest teilweise von der optischen Energie gespeist wird, die durch das Verfahren in elektrische Energie umgewandelt wird.

16. Das Verfahren nach Anspruch 11, wobei das elektrische Signal einen übermäßigen Rauschfaktor aufweist, der unter 2,0 liegt.

**Revendications**

1. Dispositif de conversion d'énergie optique-électrique, comprenant :

un substrat (110) formé d'un matériau semi-conducteur dopé, le substrat (110) comprenant une première région (111) et une seconde région (112) ;
un réseau de nanostructures multicouches (120) faisant saillie de la première région (111) du substrat (110),
dans lequel les nanostructures multicouches (120) sont formées d'un premier matériau semiconducteur co-dopé (121) recouvert d'une couche d'un second matériau semiconducteur co-dopé (122) formant une structure noyau-enveloppe,
la couche (122) recouvrant au moins une partie du matériau semi-conducteur dopé du substrat (110) dans la seconde région (112),

dans lequel les premier et second matériaux semi-conducteurs co-dopés (121, 122) comprennent des dopants accepteurs d'électrons et des dopants donneurs d'électrons, dans lesquels le premier matériau semi-conducteur co-dopé (121) comprend une plus grande concentration des dopants accepteurs ou donneurs d'un premier type que des dopants de l'autre type, et le second matériau semi-conducteur co-dopé (122) comprend une plus grande concentration des dopants de l'autre type que des dopants du premier type,

dans lequel le premier et le second matériau semi-conducteur co-dopé (121, 122) comprennent les dopants accepteurs et donneurs à un niveau de concentration d'au moins $1 \times 10^{18}$ cm$^{-3}$ pour fournir des structures de jonction co-dopées fortement compensées ; et

une électrode (130) formée sur la partie du substrat dans la seconde région recouverte de couche,

dans lequel les nanostructures multicouches (120) sont structurées pour fournir une région optique active capable d'absorber des photons de la lumière à une ou plusieurs longueurs d'onde pour générer un signal électrique présenté à l'électrode (130).

2. Dispositif selon la revendication 1, dans lequel ledit substrat comprend un premier dopant, qui comprend un type de dopant accepteur d'électrons ou dopant donneur d'électrons.

3. Dispositif selon la revendication 1, dans lequel le matériau semi-conducteur dopé comprend du silicium de type p.

4. Dispositif selon la revendication 1, comprenant en outre : une base de substrat couplée sur le côté du substrat opposé à celui du réseau de structures multicouches à échelle nanométriques et formée d'un matériau isolant électrique.

5. Dispositif selon la revendication 1, dans lequel le premier matériau semi-conducteur co-dopé comprend un matériau semi-conducteur de type p+/n, le semi-conducteur de type p+/n comprenant à la fois des dopants accepteurs d'électrons et donneurs d'électrons, dans lesquels la concentration d'accepteurs est supérieure à la concentration de donneurs; et/ou dans lequel le second matériau semi-conducteur co-dopé comprend un matériau semi-conducteur de type n+/p, le matériau semi-conducteur de type n+/p comprenant à la fois des dopants accepteurs d'électrons et donneurs d'électrons, dans lesquels la concentration de donneurs est supérieure à la concentration d'accepteurs.

6. Dispositif selon la revendication 1, dans lequel le premier et le second matériau semi-conducteur co-dopé comprennent des dopants à un niveau de concentration sensiblement de l'ordre de $1 \times 10^{19}$ cm$^{-3}$.

7. Dispositif selon la revendication 1, dans lequel l'une ou plusieurs longueurs d'onde comprennent une longueur d'onde de 630 nm, et l'absorption d'un photon rouge à la longueur d'onde de 630 nm produit au moins 4 paires électron-trou pour générer le signal électrique ; et/ou dans lequel l'une ou plusieurs longueurs d'onde comprennent des longueurs d'onde de lumière visible avec des énergies supérieures à l'énergie de bande interdite de 1,12 eV du Si.

8. Dispositif selon la revendication 1, dans lequel le réseau de nanostructures multicouches est structuré pour avoir une géométrie comprenant un ou plusieurs éléments parmi une structure en forme de fil, une structure en forme de paroi ou une structure en forme de gaufre.

9. Dispositif selon la revendication 7, dans lequel le réseau de nanostructures multicouches comprend des nanofils ayant un diamètre de sensiblement 300 nm et une hauteur de sensiblement 2500 nm.

10. Dispositif selon la revendication 1, dans lequel le dispositif génère un facteur d'excès de bruit inférieur à 2,0.

11. Procédé de conversion d'énergie optique en énergie électrique, comprenant :

fournir un dispositif de conversion d'énergie optique-électrique selon la revendication 1 ;
éclairer une surface dudit dispositif de conversion d'énergie optique-électrique
générer un signal électrique à partir de la lumière obtenue par ladite conversion optique-énergie via un mécanisme d'ionisation d'exciton en cascade au niveau du réseau de nanostructures multicouches, dans quoi le signal électrique est présenté à l'électrode (130) formée sur la partie du substrat dans la seconde région recouverte de couche ; et
fournir le signal électrique généré à un circuit électrique.

12. Procédé selon la revendication 11, dans lequel la lumière comprend une ou plusieurs longueurs d'onde comprenant une longueur d'onde de 630 nm, et dans lequel la génération du signal électrique à partir de la lumière à la longueur d'onde de 630 nm produit au moins 4 paires électron-trou pour générer le signal électrique.

13. Procédé selon la revendication 11, dans lequel :

le premier matériau de silicium co-dopé comprend un matériau de silicium de type p+/n comprenant à la fois des dopants accepteurs d'électrons et donneurs d'électrons, dans lesquels la concentration d'accepteurs est supérieure à la concentration de donneurs, et
le second matériau de silicium co-dopé comprend un matériau de silicium de type n+/p comprenant à la fois des dopants accepteurs d'électrons et donneurs d'électrons, dans lesquels la concentration de donneurs est supérieure à la concentration d'accepteurs.

14. Procédé selon la revendication 11, dans lequel le réseau de nanostructures multicouches comprend une géométrie de structures de nanofils, de structures de nanoparois ou de structure de nanogauffres.

15. Procédé selon la revendication 11, dans lequel la lumière comprend la lumière du soleil et le circuit électrique est inclus dans un dispositif au moins partiellement alimenté par l'énergie optique convertie en énergie électrique par le procédé.

16. Procédé selon la revendication 11, dans lequel le signal électrique présente un facteur d'excès de bruit qui est inférieur à 2,0.

FIG. 1

FIG. 2A

FIG. 2B

FIG. 2C

FIG. 2D

FIG. 3

Donor state
Acceptor state

light

$p^+(n)$ co-
doped p-
layer)

$n^+(p)$ co-doped
n-layer)

Nanowire

**FIG. 4A**

Electron accelerated
by crossing the
potential cliff

**FIG. 4B**

$1^{st}$ avalanche
multiplication to ionize
the bound D+/A- exciton

Probability of $1^{st}$ avalanche: $P_1$

**FIG. 4C**

Hole accelerated by crossing the potential cliff

2$^{nd}$ avalanche multiplication to ionize the bound (D+/A-) exciton

Electron accelerated by crossing the potential cliff to initiate the 3rd avalanche

Probability of 2$^{nd}$ avalanche: $P_1 P_2$

Probability of 2$^{nd}$ avalanche: $P_1 P_2 P_1$

FIG. 4D

FIG. 4E

FIG. 4F

Conventional device

Voc

Isc

Device of
Disclosed Technology

Isc

The rectangular area represents
the power conversion (square)
efficiency of solar cell

FIG. 5

FIG. 6

Responsivity vs. Spectrum of NWs

FIG. 7A

Quantum Efficiency vs. Spectrum of NWs

FIG. 7B

820A

110

130

FIG. 8A

820B

110

130

FIG. 8B

820C

110

130

FIG. 8C

FIG. 9A

FIG. 9B

FIG. 10A

FIG. 10B

FIG. 10C

FIG. 10F

FIG. 10E

FIG. 10D

FIG. 11A

FIG. 11B

EP 2 973 712 B1

FIG. 11C

FIG. 12A

450 nm　　　　532 nm　　　　635nm

FIG. 12B

FIG. 12C

FIG. 12D

FIG. 13A

FIG. 13B

FIG. 13C

FIG. 14

FIG. 15A

FIG. 15B

FIG. 16A

FIG. 16B

FIG. 17A

FIG. 17B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012196401 A1